(19) Europäisches Patentamt
European Patent Office
Office européen des brevets

(11) EP 2 019 486 B1

(12) EUROPEAN PATENT SPECIFICATION

(45) Date of publication and mention
of the grant of the patent:
**10.12.2014 Bulletin 2014/50**

(51) Int Cl.:
*H03F 1/32* (2006.01)    *H04L 27/36* (2006.01)
*H04B 1/04* (2006.01)

(21) Application number: 07113377.1

(22) Date of filing: **27.07.2007**

(54) **RF transmitters**

HF-Sender

Transmetteurs RF

(84) Designated Contracting States:
**DE FR GB**

(43) Date of publication of application:
**28.01.2009 Bulletin 2009/05**

(73) Proprietor: **Fujitsu Semiconductor Limited**
**Kohoku-ku, Yokohama-shi**
**Kanagawa 222-0033 (JP)**

(72) Inventor: **Dedic, Ian Juso**
**Northolt, Middlesex UB5 5HW (GB)**

(74) Representative: **Wilding, Frances Ward**
**Haseltine Lake LLP**
**Lincoln House, 5th Floor**
**300 High Holborn**
**London WC1V 7JH (GB)**

(56) References cited:
**US-A- 4 291 277    US-A- 6 141 390**

• **LEE H-S ET AL: "Radio Frequency Digital-to-Analog Converter" IEEE JOURNAL OF SOLID-STATE CIRCUITS, IEEE SERVICE CENTER, PISCATAWAY, NJ, US, vol. 39, no. 9, September 2004 (2004-09), pages 1462-1467, XP011117965 ISSN: 0018-9200**

**Description**

The present invention relates to RF transmitters, in particular to architectures of such transmitters.

RF transmitters in general have been previously considered, in which a digital data signal is converted to an analogue RF signal for transmission. US 2007/0030065 A1 discloses such an RF transmitter. Due to non-linear effects of analogue components of the transmission chain, the transmission signal is distorted in amplitude and phase. The main cause for such distortions is the power amplifier in the transmission chain. In addition to amplifying a desired signal, the power amplifier generates higher order harmonics of the original signal spectrum. The spread of the signal spectrum causes two major effects: a radio frequency spectrum mask does not fulfil the requirements for out-of-band radiated power, and detection of a distorted signal in a receiver suffers from errors.

In US 2007/0030065 A1, the spread of the signal spectrum is reduced using a linearization technique known as pre-distortion. As previously mentioned, the main cause for distortions is non-linearity of the power amplifier. Power amplifiers are required in radio systems to amplify signals before transmission, because radio signals attenuate on the radio path. Unfortunately, high-power radio-frequency amplifiers tend to be non-linear devices and therefore they often cause distortion. This distortion is expressed, for example, as Inter-Symbol-Interference or out-off-band power in adjacent frequency bands. An ACLR (Adjacent Carrier Leakage Ratio) quantifies the out-off-band transmitted power and typically must remain within specified limits.

Linear amplification is mostly needed when the transmitted signal contains both amplitude and phase modulation. Examples of these modulation methods include quadrature phase-shift keying (QPSK) and orthogonal frequency division multiplexing (OFDM).

Pre-distortion generates a non-linear transfer function which can be thought of as a reverse of the power amplifier's transfer function taking into account both amplitude and phase. In other words, pre-distortion is designed to provide distortion complementary to that of the power amplifier in a signal for transmission prior to its input to the power amplifier, producing an overall linear transfer function.

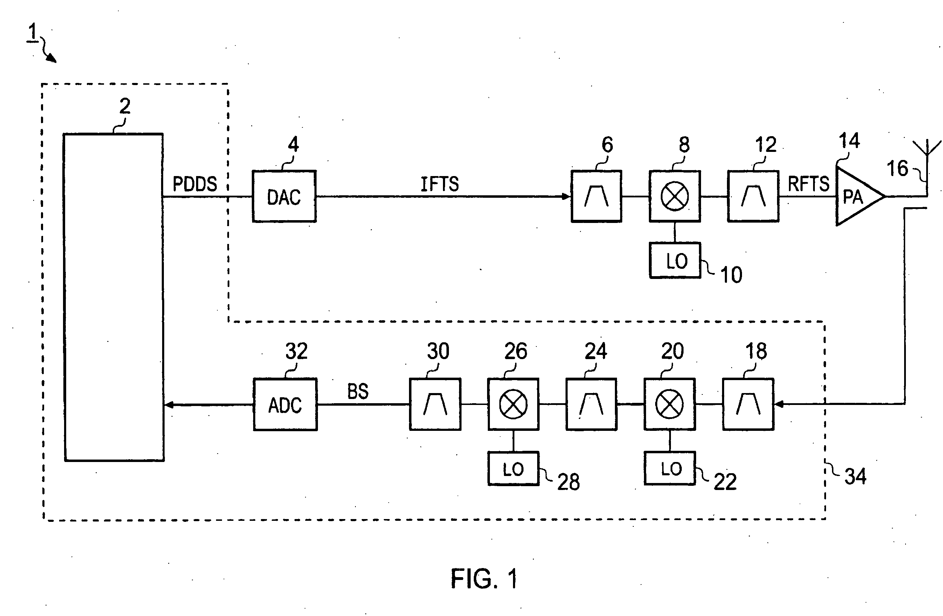

Figure 1 is a schematic diagram of a previously-considered RF transmitter 1 which may be considered to some extent to be equivalent to the RF transmitter of US 2007/0030065 A1.

RF transmitter 1 comprises a digital pre-processing section 2, a digital-to-analogue converter (DAC) 4, a filter 6, an analogue mixer 8, a local oscillator 10, a filter 12, a power amplifier (PA) 14, an antenna 16, a filter 18, an analogue mixer 20, a local oscillator 22, a filter 24, an analogue mixer 26, a local oscillator 28, a filter 30, and an analogue-to-digital converter (ADC) 32.

DAC 4, filter 6, mixer 8, filter 12 and PA 14 are connected in series between the digital pre-processing section 2 and the antenna 16. Filter 18, mixer 20, filter 24, mixer 26, filter 30 and ADC 32 are connected in series between a coupler at the antenna 16 and the digital pre-processing section 2. Local oscillators 10, 22, and 28 are connected to mixers 8, 20 and 26, respectively.

In use, digital pre-processing section 2 outputs a pre-distorted digital data signal (PDDS) to the DAC 2. The pre-distorted digital data signal is a pre-distorted version of an intended digital data signal. The pre-distortion is applied to the intended digital data signal to generate the pre-distorted digital data signal in the digital pre-processing section 2. This pre-distortion is intended to compensate for (or cancel out) distortion caused in the power amplifier 14, as will become apparent.

DAC 4 receives the pre-distorted digital data signal PDDS and outputs an analogue transmission signal. DAC 4 is a high-speed high-precision DAC, for example a 14-bit, 1 GSa/s DAC. Accordingly, DAC 4 is capable of outputting directly an analogue transmission signal at an intermediate frequency (IF), for example, at 300MHz. This IF transmit signal (IFTS) is filtered by filter 6 and then up-converted to radio frequency (RF) by mixer 8 and local oscillator 10. The output signal of the mixer 8 is filtered by filter 12 and input as an RF transmit signal (RFTS) to the power amplifier 14. The output of the power amplifier 14 is supplied to the antenna 16 for transmission.

As already mentioned, the intended digital data signal is pre-distorted (to form the pre-distorted digital data signal PDDS) in the digital pre-processing section 2 to compensate for distortion caused in the power amplifier 14, so as to effectively linearize the operation of the power amplifier 14. In order to perform such linearization, the pre-distortion applied by the digital pre-processing section 2 is controlled in dependence upon a measure of the distortion caused by the power amplifier 14.

In order to gain a measure of the distortion in the power amplifier 14, the digital pre-processing section 2 requires a digitized version of the amplified RF transmit signal output by the power amplifier 14. Digitization of the amplified RF transmit signal directly, at the required resolution, is not possible with conventional ADCs, and even digitization of IF signals at the required resolution is difficult to do directly, as will become apparent. Accordingly, the RF transmitter 1 down-converts the amplified RF transmit signal to a baseband signal (BS) ready for digitization.

The down-conversion in the RF transmitter 1 is performed in two stages, i.e. by two series-connected down-converters. The first of those down-converters is formed by mixer 20 and local oscillator 22, and the second of those down-converters is formed by mixer 26 and local oscillator 28. Filters 18, 24, and 30 filter the signals as the down-conversion is performed.

The analogue baseband signal BS ready for digitization is applied to the input of ADC 32. The ADC 32 converts the analogue baseband signal BS into a digital signal and delivers it to the digital pre-processing section 2. The digital pre-processing section 2 compares the digital signal received from ADC 32 with the intended digital data signal, and controls the pre-distortion applied to the intended digital data signal in dependence upon such comparison. In this way, it is possible to effectively linearize the operation of the power amplifier 14.

For the benefit of later explanation, the elements of RF transmitter 1 within dashed box 34 may be considered to form signal generation means 34 of RF transmitter 1.

The architecture of the RF transmitter 1 causes it to suffer a number of problems. The RF transmitter 1 is relatively costly, because it comprises one up-conversion stage (mixer 8 and local oscillator 10) and one or two down-conversion stages (one or both of mixer 20 and local oscillator 22, and mixer 26 and local oscillator 28). The ADC 32 is relatively expensive and consumes a relatively large amount of power because it must be a high-performance device. The analogue mixers, local oscillators, and filters which form part of the feedback path of RF transmitter 1 must be relatively expensive and consume a relatively large amount of power because they must also be high-performance devices. The analogue mixers, local oscillators, and filters which form both the transmit and feedback paths of the RF transmitter 1 must be different for different radio bands (e.g. between a CDMA 2000 system and a W-CDMA system). Accordingly, it is difficult to design such RF transmitters to be suitable for use in different radio system types (for example in base stations which, from one base station to the next, or from one transmission period to the next, employ different communication standards and corresponding frequency bands). The RF transmitter 1 does not lend itself to the ideal concept of software-defined radio, in which nothing other than the software need be changed in order to change transmission from one band to the next. In order to better understand these problems, the RF transmitter 1 will be considered further.

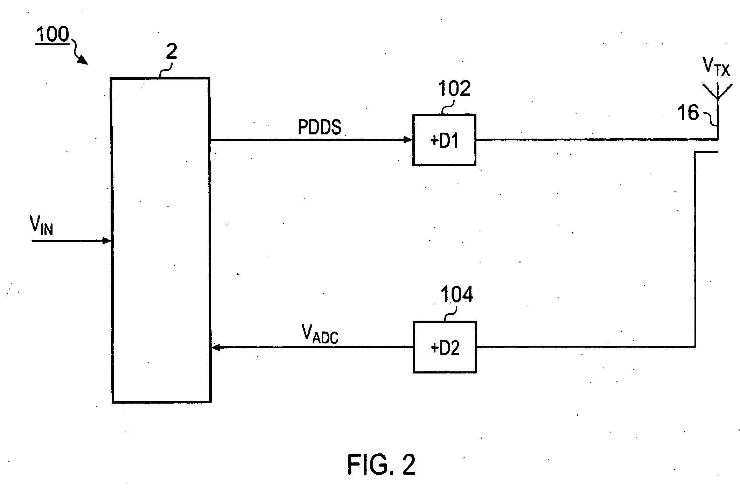

Figure 2 is a simplified schematic diagram 100 of RF transmitter 1. Accordingly, like RF transmitter 1, schematic diagram 100 comprises digital pre-processing section 2 and antenna 16. The components of the transmission path from digital pre-processing section 2 to antenna 16 have been represented by a single block 102 which adds distortion D1 to a signal passing therealong. Similarly, the components of the feedback path from antenna 16 back to digital pre-processing section 2 have been represented by a single block 104 which adds distortion D2 to a signal passing therealong.

As can be seen from Figure 2, the digital pre-processing section 2 receives an intended digital data signal $V_{IN}$ and outputs a pre-distorted digital data signal PDDS based thereon. Incidentally, although the received signal $V_{IN}$ is not shown in Figure 1 or in other accompanying Figures, this signal is of course assumed to be received from other parts of the RF transmitter concerned not shown for simplicity. The antenna 16 transmits an analogue RF signal $V_{TX}$ based upon the pre-distorted digital data signal PDDS, and the digital pre-processing section 2 receives a digital feedback signal $V_{ADC}$ (which may be considered to be the output of the ADC 32 of Figure 1) based upon the analogue RF signal $V_{TX}$.

Based on Figure 2, it can therefore be seen that:

$$V_{TX} = PDDS + D1$$

$$V_{ADC} = V_{TX} + D2 = PDDS + D1 + D2$$

The pre-distortion performed in digital pre-processing section 2 serves to adapt the pre-distorted digital data signal PDDS until the feedback signal $V_{ADC}$ is the same as the intended signal $V_{IN}$, because at this point it appears to the digital pre-processing section 2 that the transmit path (including the power amplifier and other analogue components) has been effectively linearized. It will of course be appreciated that, in practice, it is not possible to achieve perfect pre-distortion (i.e. linearization), however for the benefit of further explanation it can be seen that at the point of "perfect" linearization:

$$V_{ADC} = V_{IN}$$

so that:

$$PDDS + D1 + D2 = V_{IN}$$

Accordingly, at the point where the digital pre-processing section 2 appears to have linearized the transmit path, it can be seen that:

$$PDDS = V_{IN} - D1 - D2$$

and therefore that:

$$V_{TX} = PDDS + D1$$
$$= V_{IN} - D2$$

Accordingly, it can be seen that a fundamental feature of the Figure 1 architecture is that even if the pre-distortion performed by digital pre-processing section 2 is "perfect", the quality of the transmit signal $V_{TX}$ is limited by the distortion D2 generated by the components in the feedback path. It will be appreciated that the Figure 1 architecture therefore places significant pressure on the components in the feedback path, which include mixers, local oscillators, filters and an ADC.

In order to further consider the pressure placed on the components in the feedback path, it is necessary to more closely consider the power amplifier employed in the transmit path, for example power amplifier 14 of Figure 1.

To define the performance of a power amplifier (or, for example, a mixer) in a transmitter, various specifications are recorded which are obtained from measurements or simulations carried out. Intermodulation performance, which considers distortion caused by intermodulation products is of particular importance and will be considered further.

When a single frequency (f1) is fed through a device such as a power amplifier whose output is not a linear function of its input, harmonics of f1 are generated, i.e. 2f1, 3f1, 4f1, 5f1, etc. No device is perfect, and so harmonics are always generated, although often only at low levels. If two separate frequencies exist together in a non-linear device such as a power amplifier, sum and difference frequencies are also produced in addition to the harmonics. This can be shown mathematically to be the result of a multiplication process between the two original frequencies, and hence the two new frequencies are called products. If the two original frequencies are f1, f2 and the highest frequency is f2, then two other components (or products) of the fundamental frequencies f1 and f2 are produced, namely (f1+f2) and (f2-f1). Further, since there are harmonics of f1 and f2, then there will be sum and difference products between all of the harmonics and the fundamentals and between each other. These are known as the intermodulation products which are frequency components distinct from the harmonic components discussed above. Of course, if there are more than two fundamental frequencies, e.g. f1, f2 and f3, then the multitude of products is compounded further.

It can be shown, using a mathematical series, that when harmonics are generated, the harmonics extend upward in frequency to approach infinity, progressively decreasing in amplitude as the frequency increases. Likewise, the intermodulation products could also be considered to be infinite in number. Of course, only certain such products cause significant signal deterioration, and are therefore of practical significance.

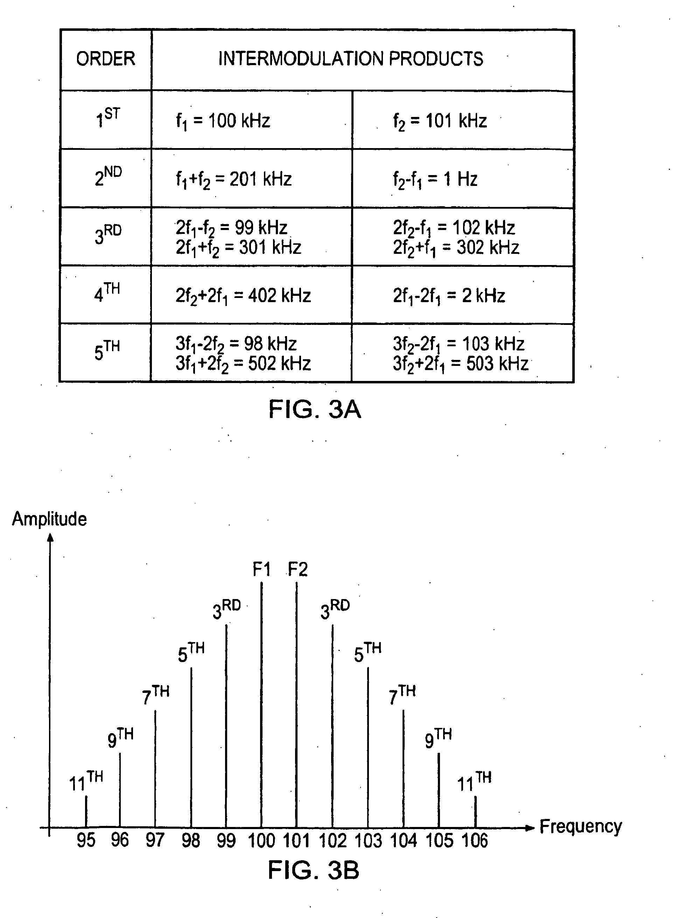

To understand intermodulation products, two frequencies f1 and f2 and some of the orders of intermodulation products will be considered. To define the order, the harmonic-multiplying constants of the two frequencies producing the intermodulation product concerned are summed together. For example, (f1+f2) is second order, (2f1-f2) is third order, (3f1-2f2) is fifth order. By way of example, f1 and f2 are considered to be two frequencies of 100 kHz and 101 kHz respectively, that is 1 kHz apart. Figure 3A is a table showing a number of the low-order intermodulation products of frequencies f1 and f2.

By examining the Figure 3A table, it can be seen that only the odd-order intermodulation products are close to the two fundamental frequencies f1 and f2. One third-order product (2f1-f2) is 1 kHz lower in frequency than f1, and another (2f2-f1) is 1 kHz above f2. One fifth-order product (3f1-2f2) is 2 kHz below f1 and another (3f2-2f1) is 2 kHz above f2. In fact, it will be appreciated that it is the odd-order products which are closest to the fundamental frequencies f1 and f2. The series of odd-order products can be seen to descend and ascend progressively in increments of 1 kHz (the difference between f1 and f2) from the two fundamental frequencies f1 and f2, respectively. A typical spectrum produced could be depicted as shown in the graph of Figure 3B.

Of all the harmonics and intermodulation components produced, practical design only requires consideration of those that fall in the passband of the RF transmitter and its corresponding receiver and, in the case of the intermodulation components, those which happen to be closest to the fundamental frequencies. The third-order components are the closest and also usually the highest in amplitude. Because of this, they are usually the products of most concern and are those which are commonly measured and defined in transmitter and receiver performance specifications.

The existence of intermodulation components generated by a power amplifier affects the performance of the RF transmitter in various ways. The presence of any component at the output of an amplifier, but not fed into it, degrades the quality of the signal being amplified. This is known as distortion, which can be the result of non-linearity in the power amplifier as mentioned above causing the generation of harmonics of the signal frequencies and, in turn, intermodulation components. It can therefore be seen that both harmonic distortion and intermodulation distortion are generated.

Some different effects can be experienced when non-linearity exists in an RF transmitter and, in particular, in the final power amplifier of the transmitter. If the amplifier delivers sideband components to the antenna at radio frequencies, then, because of nonlinearity, harmonics of the various sideband components are generated plus various intermodulation components. The harmonic components and the even- order intermodulation components will normally be well spaced away from the operating frequency, and hopefully attenuated by filtering in the transmission path. However, the odd-order intermodulation components will be closely spaced around the fundamental components from which they were generated. As already mentioned, the odd-order components spread out either side of the fundamental components in progression gradually decreasing in amplitude. The effect is to broaden the radiated signal and, in receiving the signal, the distortion is experienced.

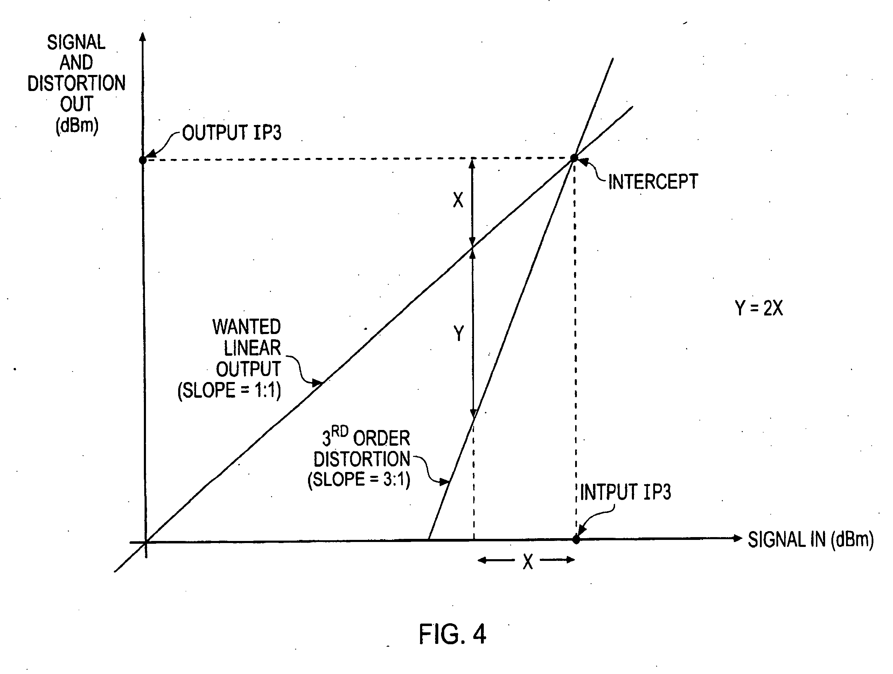

Figure 4 is a graph for explaining the concept of the third-order intercept point (IP3). The IP3 is used to consider how to operate the power amplifier in the RF transmitter 1.

The graph of Figure 4 is essentially a plot of output power versus input power for the device, in this case the power amplifier, on a dBm scale. Two traces are shown on the graph, one of the linearly amplified signal (the wanted signal) and the other for a $3^{rd}$ order intermodulation distortion product. On a logarithmic scale, the linearly amplified signal exhibits a straight line with a slope of 1. Accordingly, the $3^{rd}$ order distortion exhibits a straight line with a slope of 3. It will of course be appreciated that $5^{th}$ and $7^{th}$ order distortion would exhibit straight lines with slopes of 5 and 7, respectively. Because in many systems only the $3^{rd}$ order intermodulation products need be considered, higher odd-ordered intermodulation products have not been shown in Figure 4.

Both traces in Figure 4 are extended to the point where they intersect one another. This point is known as the third-order intercept point (IP3). The corresponding points on the input and output power axes are known as the third-order input and output intercept points (IIP3 & OIP3), respectively.

By considering the graph of Figure 4, it can be seen that by operating at a high input power level, at or approaching the IIP3, the non linear products become proportionally larger, such that at higher input power levels the power amplifier behaves particularly non-linearly. Conversely, by operating at low input power levels, significantly lower than the IIP3, the non-linear products become proportionally smaller, such that at lower input levels the power amplifier behaves in a more linear manner. This is indicated on the Figure 4 graph by the dimensions X and Y. Because of the relative gradients of the two traces, Y = 2X. Therefore, by operating with an input power level 30 dBm below the IIP3, the output $3^{rd}$ order distortion component will be 60 dBm below the output linear signal component. By operating with an input power level 40 dBm below the IIP3, the output $3^{rd}$ order distortion component will be 80 dBm below the output linear signal component.

Based on the above, it can be appreciated that, from the point of view of distortion, it is better to operate a power amplifier with a relatively small input power level relative to its IIP3. However, this is an inefficient way to operate a power amplifier and leads to a high power consumption. Mains power consumption in practical RF transmitters, for example employed in base stations for mobile networks, is of particular concern and is a significant contributor to operating costs for such networks. Accordingly, a high degree of importance is placed on reducing mains power consumption in RF transmitters.

Low mains power consumption is achieved by operating at an input power level closer to the IIP3. The reduction in distortion in the transmitted RF signal provided by the pre-distortion technique (i.e. the effective linearization of the power amplifier) enables the RF transmitter to operate in this way without significantly increasing the distortion in the transmitted RF analogue signal. Typically, 30dB distortion cancellation can be achieved through use of the pre-distortion technique, i.e. typically it is possible to raise the power amplifier power level by 15dB. For example, whereas (without pre-distortion) it may be preferable to operate 35 dB below the IIP3, pre-distortion typically enables operation at around 20 dB below the IIP3 with comparable distortion performance (i.e. at 15 dB higher than without pre-distortion). However, by operating at this kind of input power level, the power amplifier is particularly non-linear, which causes design difficulties as follows.

By operating at only around 20 dB below the IIP3, not only is $3^{rd}$ order distortion significant, but $5^{th}$ order (and possibly $7^{th}$ order or higher) distortion becomes significant. For example, by increasing a power-amplifier power level by 15dB, $3^{rd}$ order distortion relative to the wanted signal increases by 30dB. However, 30dB cancellation is, in this example, provided through pre-distortion and accordingly the level of the third order distortion remains unchanged. By this 15dB increase in power-amplifier power level, 5th order distortion relative to the wanted signal increases by 60dB, and $7^{th}$ order distortion relative to the wanted signal increases by 90dB. These increases exceed the 30dB cancellation provided through pre-distortion. Therefore, depending on the pre-power-increase levels of the $5^{th}$ and $7^{th}$ order distortion components, it can be appreciated that in order to carry out effective pre-distortion it can be necessary to "measure" at least $3^{rd}$ and $5^{th}$ (and possibly $7^{th}$) order distortion generated in the power amplifier.

As mentioned above, the effect of transmission signal distortion is to broaden the transmission signal in frequency. A typical RF transmit channel may have a bandwidth of, for example, 20 MHz. Third order distortion may thus cause spread of this channel over 60 MHz, and fifth order distortion may cause spread over 100 MHz. In order to "measure" this distortion, the ADC 32 in the feedback path of RF transmitter 1 may therefore, for example, need to have a sample rate of around 250 MSa/s (i.e. over twice 100 MSa/s) in order to perform Nyquist sampling of the $5^{th}$ order distortion components.

Also as mentioned above, with reference to Figure 2, the performance of the Figure 1 architecture is limited by the distortion in elements of its feedback path, one of which is the ADC 32. Therefore, in order to sample the $5^{th}$ order distortion component whilst imposing minimum distortion itself, the ADC 32 must be a high-performance device, for example a 12-bit, 250MSa/s device (in the case of Nyquist sampling). These ADC requirements are towards the edge of the existing ADC capabilities. Accordingly, it will be appreciated that as channel bandwidths rise above 20 MHz, for example to 50 MHz or 100 MHz, such RF transmitters will suffer from increasingly poor distortion performance.

In addition to the ADC 32, the elements in the feedback path of RF transmitter 1 comprise mixers 20 and 26, local oscillators 22 and 28 and filters 18, 24 and 30. These elements, in addition to the ADC 32, must also be high performance devices in order to enable RF transmitter 1 to function satisfactorily. For example, the feedback path must have an IIP3 of at least 30 dBm, requiring each mixer to have, for example, an IIP3 of at least 35 dBm. Such elements are expensive and power hungry. In order to limit the necessary speed of the ADC 32, filter 30 is required to have a significantly steep transfer function, which makes it a costly element of the RF transmitter. Reducing the specification of filter 30 would require a faster ADC 32 which is undesirable. As can be seen, the result is that RF transmitter 1 has an expensive, difficult to design, feedback path.

A particular problem with employing high IIP3 components, other than their expense and power consumption, is in terms of system integration. It is desirable to implement as much of RF transmitter 1 on a single chip as possible, for example using small-geometry CMOS technology. It will be appreciated that digital pre-processing section 2, DAC 4 and ADC 32 may be implemented together on a single such chip using small-geometry CMOS technology. However, high IIP3 mixers of the type required in RF transmitter 1 are typically implemented using Schottky diode technology, gallium arsenide (GaAs) FET technology, or silicon-on-insulator MOS technology. None of these technologies are compatible with small-geometry CMOS technology chips and therefore such mixers must be external off-chip devices requiring their own power supplies and other driving circuitry. Further, in the case of Schottky-diode technology mixers, the associated local oscillator required may be for example a +23 dBm local oscillator (i.e. 3.5 V rms) which again is not compatible with small-geometry CMOS technology.

In addition to the high specification requirements and difficulty in integration of the elements of RF transmitter 1, a number of those components must be changed when the band of transmission is changed. Typically, some or all of analogue components 6, 8, 10, 12, 14, 18, 20, 22, 24, 26, 28 and 30 will need to be changed when the band of transmission is changed. This gives rise to multiple sets of analogue components which are switched in and out of circuit depending on the band of transmission, which still further increases complexity and cost of RF transmitter 1.

It is desirable to solve one or more of the above-mentioned problems.

A paper entitled "Multicarrier WCDMA Feasibility", by Brad Brannon and Bill Schofield of Analog Devices, published at www.analog.com, discloses a number of flexible radio platform architectures. This paper is an overall summary of technical teaching in the field of the present invention, and it is noted that the RF system architectures considered therein are all analagous to that of the present Figure 1.

In US4291277, distortion introduced into a multiamplitude signal format by a high power microwave amplifier is compensated by a system which adapts itself to non-linearities present in the amplifier and predistorts the input signals before they are subjected to the non-linearities created by the amplifier. The degree of predistortion is non-fixed and varies or is updated as the non-linear conversion characteristics of the amplifier change with time. In the disclosed system, digital-to-analogue conversion is carried out at baseband, and thus analogue frequency up-conversion is carried out in the transmission path.

A paper entitled "Radio frequency digital-to-analog converter, by Luschas, S et al, IEEE Journal of Solid-State Circuits, Sept. 2004, Volume 39, Issue: 9, pages 1462-1467, discloses high-speed high-resolution digital-to-analog converters (DACs) in which dynamic performance is limited by distortion at the data switching instants. Inter-symbol interference (ISI), imperfect timing synchronization, and clock jitter are considered. A DAC output controlled by an oscillating waveform is proposed in the paper to mitigate the effects of switching distortion and clock jitter.

US6141390 discloses a system for linearly transmitting an amplified output signal using predistortion. The system uses a straight inverse modelling scheme with orthogonal predictor variables to more easily and accurately determine the inverse of the distortion caused by a power amplifier of an RF transmitter. The direct inverse modelling scheme disclosed indexes the LUT (lookup table) using the modulated input signals instead of the potentially nosier output signals, which helps to increase the accuracy of the predistortion. The predistorter system stores complex coefficients in the LUT, which are then used as the tap weights of a non-linear digital filter implementing the predistorter. Finally, the trainer uses a modified version of the power amplifier output signal which results in better predistortion performances. The modified power amplifier output signal has the in-band distortion removed from the power amplifier output signal.

There is disclosed herein an RF transmitter, comprising: signal generation means operable to generate first and second digital RF signals in dependence upon data to be transmitted, the first digital signal being a pre-distorted version of the second digital signal; first DAC means operable to convert the first digital RF signal into a first analogue RF signal; second DAC means operable to convert the second digital RF signal into a second analogue RF signal; an amplifier, operatively connected to the first DAC means, for producing an amplified transmission signal in dependence upon the first analogue RF signal; an antenna operatively connected to said amplifier for transmitting said amplified transmission signal; and an error-signal generator, operatively connected to the antenna and the second DAC means, for producing an error signal in dependence upon a difference between the transmission signal and the second analogue RF signal; wherein said signal generation means is operatively connected to the error-signal generator to control generation of said first digital RF signal in dependence upon said error signal so as to tend to reduce said difference.

The present invention is defined by the independent claims, to which reference should now be made. Specific embodiments are defined in the dependent claims.

In the context of the present invention, the digital RF signals are essentially a succession of samples such that when (directly) converted into an analogue signal in the DAC means the analogue signal concerned is a corresponding RF signal. Put another way, the digital RF signals are essentially a succession of samples of the corresponding analogue RF signals such that those analogue RF signals are created by digital-to-analogue conversion of those digital signals in the DAC means. Put yet another way, the wanted part of the frequency spectrum of such a digital RF signal will be essentially the same as the wanted part of the frequency spectrum of the corresponding analogue RF signal.

Because the generation of the first digital RF signal is controlled in dependence upon the error signal, and that error signal is generated in dependence upon a difference between the transmission signal and the second analogue RF signal, the distortion performance imposed on the signal generation means of the present aspect of the present invention in sampling the signal in the feedback path (in this case the error signal) is substantially less than is imposed on the signal generation means of previously-considered RF transmitter 1 to sample the signal in the feedback path of that transmitter. Accordingly, the signal generation means of the present aspect of the present invention can be realised with simpler, cheaper, less power-hungry, lower distortion-performance components than in RF transmitter 1. The signal generation means of the present aspect of the present invention can for example be implemented in small-geometry CMOS technology IC (integrated circuit) chip.

Because the DAC means of the present invention receive digital RF signals and output analogue RF signals, there is no requirement for analogue frequency up-conversion means in the RF transmitter of the present aspect of the present invention. This leads to a low cost design, and a greater flexibility in frequency band of transmission. Such a transmitter can preferably output transmission signals in different frequency bands from one time to the next, by changing the first and second digital RF signals, thereby approximating a software-defined radio. It is envisaged that such a transmitter may only require a number of filters, if any, and the power amplifier to be changed in order to swap from one such frequency band of transmission to the next. It is also envisaged that a wideband power amplifier may be employed, such that a single such power amplifier may be used for a plurality of different frequency bands.

It will be appreciated that the signal generation means may comprise digital and analogue circuitry and circuitry for converting digital signals to analogue signals and vice versa. It will be appreciated that the DAC means may comprise a single DAC or a plurality of DACs. The amplifier may be a power amplifier, for example a Multi-Carrier Power Amplifier (MCPA). The amplifier may include one or more pre-amplification stages and/or one or more signal-filtering stages. The error signal may comprise any circuitry operable to produce an error signal in dependence upon a difference between two input signals, for example a subtractor.

It will be understood that the term RF (radio frequency) is intended in the context of the present invention to mean frequencies at which a radio signal is transmitted, typically 800 MHz or above. It will be understood that the term baseband is intended in the context of the present invention to mean frequencies at which a signal intended for radio transmission is generated (or analysed following reception), typically 200 MHz or below. It will be understood that the term IF (intermediate frequency) is intended in the context of the present invention to mean frequencies in-between baseband and RF used as an intermediate stage during conversion from baseband to RF, or vice versa.

The signal generation means may comprise ADC means connected for receiving the error signal in analogue form from the error-signal generator and operable to convert the analogue error signal into a corresponding digital signal. For example, the signal generation means may comprise a digital pre-processing section operable to control the distortion applied to the second digital RF signal, or a digital signal from which the second digital RF signal is derived, to generate the first digital signal, so as to reduce the above-mentioned difference. In that case, the ADC means may be operable to convert the analogue error signal into a digital signal for input to such a digital pre-processing section. The ADC means may comprise a single ADC or a plurality of ADCs.

It will be appreciated that the ADC means of the present aspect of the present invention may advantageously be simpler, cheaper, and less power-hungry than an equivalent ADC means of the RF transmitter 1, due to the reduced distortion performance imposed on the signal generation means of the present aspect of the present invention as discussed above.

Preferably, the signal generation means comprises digital frequency up-conversion means operable to generate said first and second digital RF signals from respective first and second digital baseband signals. Such up-conversion means may comprise a plurality of stages of frequency up-conversion and such stages may be separated apart by one or more digital modulation stages.

The frequency down-conversion carried out by the frequency-down-conversion means may be to an IF signal or a baseband signal. The down-conversion is advantageous as it reduces the burden placed on the signal generation means in dealing with the error signal, for example if ADC means deals with the error signal, such ADC means may be relatively low-cost, and may consume a relatively small amount of power.

The error signal may be an analogue RF signal, in which case the frequency down-conversion means may comprise an analogue mixer. In that case, the signal generation means preferably generates a digital local oscillator signal and comprises third DAC means operatively connected to convert the digital local oscillator signal into an analogue local oscillator signal for use by the analogue mixer to perform such shift in frequency. It is advantageous to generate the analogue local oscillator signal digitally in this way, as an analogue local oscillator is not then required, and because the frequency of the generated analogue local oscillator signal can be controlled digitally, ultimately in software. Again, the present aspect of the present invention advantageously enables a software-defined radio to be realised.

The error signal may be an analogue RF signal. In that case, the signal generation means preferably generates a digital local oscillator signal, and the frequency down-conversion means preferably comprises further DAC means operatively connected to receive the error signal and the digital local oscillator signal, and that further DAC means is preferably operable to perform the shift in frequency in dependence upon said digital local oscillator signal. It is advantageous to perform the shift in frequency in this way, as neither an analogue local oscillator nor an analogue mixer is then required. Because the frequency of the digital local oscillator signal can be controlled digitally, ultimately in software, the present aspect of the present invention advantageously enables a software-defined radio to be realised. In this way, the RF transmitter of the present aspect of the present invention requires no analogue frequency-conversion means, and all frequency conversion is controlled digitally.

In order to perform such a frequency shift, the further DAC means may comprise current-source means operable to source or sink current of a controllable magnitude; and the current-source means may be connected such that the magnitude is controlled in dependence upon the error signal. The DAC means in this case may comprise a DAC of the current-steering type.

The first and second digital RF signals may each represent complex signals having I and Q components, and may thus each comprise a pair of I-component and Q-component digital RF signals. In that case, the first and second DAC means may each comprise a pair of DACs for converting the I and Q-component digital RF signals of the digital RF signal concerned into respective I and Q-component analogue RF signals. The further DAC means may also comprise a pair of DACs for shifting I and Q components of the error signal down in frequency.

The second DAC means preferably comprises at least one DAC configured to operate at a sample rate substantially equal to 12GSa/s. As will be appreciated, this DAC means is more important in terms of distortion performance than other DAC means of the transmitter. Preferably, however each said DAC means comprises at least one DAC configured to operate at a sample rate substantially equal to 12 GSa/s. It is advantageous from a system design point of view to use substantially the same circuit design for each of the DAC means.

The sample rate 12GSa/s is a preferable sample rate because at this sample rate the closest spurious distortion component is more than 400MHz away from the band edge for a number of commercially important common RF frequency bands. The sample rate 11796 MSa/s is particularly preferably from this point of view. This sample rate is close to 12GSa/s and is very close to a multiple of the frequency 3.84 MHz (3.84*3072=11796.48). The frequency 3.84 MHz is the base data rate employed in conventional communications equipment such as base stations, and therefore it is advantageous to employ a sample rate that is a multiple of this base rate. However, it will be appreciated that the sample rate 12GSa/s is preferable given a particular set of commercially important common RF frequency bands. Therefore, a different sample rate may of course be preferable given a different set of commercially important common RF frequency bands. Further, a multiple of 3.84 MHz close to that different sample rate will be preferable in that case. Generally, it is advantageous to use a sample rate substantially in the range 5 to 20 GSa/s. The lower value 5 GSa/s is generally necessary for direct conversion of digital RF signals to analogue RF signals. Further, generally the higher the sample rate, the greater the chance of it being a preferable sample rate for a plurality of RF frequency bands, due to the spreading-out effect of the frequency spectrum.

Preferably the signal generation means and the DAC means are provided together on a single IC chip. This is advantageous from the point of view of integration of the elements of the transmitter, and in minimising the number of separate components of such a transmitter. It will be appreciated that the elimination of analogue components in the transmit paths and the reduction in distortion performance required in the feedback path enables such integration to be achieved.

Preferably, the error-signal generator comprises: a first input terminal operatively connected to the antenna to receive a first input signal in dependence upon said transmission signal; a second input terminal operatively connected to the second DAC means to receive a second input signal in dependence upon said second analogue RF signal; an output terminal from which said error signal is output; a resistor connected between said first input terminal and said output terminal; and a capacitor connected between said second input terminal and said output terminal. By comprising substantially only a resistor and a capacitor, such an error-signal generator can be implemented with ease and at low cost in the RF transmitter.

There is disclosed herein an IC chip or chipset for use in an RF transmitter, the RF transmitter comprising an amplifier, an antenna operatively connected to said amplifier for transmitting an amplified transmission signal output by said amplifier, and an error-signal generator operatively connected to the antenna for producing an error signal in dependence upon a difference between the transmission signal and another signal, the chip or chipset comprising: signal generation means operable to generate first and second digital RF signals in dependence upon data to be transmitted, the first digital RF signal being a pre-distorted version of the second digital RF signal; first DAC means operable to convert the first digital RF signal into a first analogue RF signal for input to the amplifier to generate said amplified transmission signal; and second DAC means operable to convert the second digital RF signal into a second analogue RF signal for input to the error-signal generator as said other signal, wherein said signal generation means is connectable to the error-signal generator to receive said error signal, and is operable to control generation of said first digital RF signal in dependence upon said error signal so as to tend to reduce said difference.

There is disclosed herein a circuit board for use in an RF transmitter, the RF transmitter comprising an amplifier and an antenna operatively connected to said amplifier for transmitting an amplified transmission signal output by said amplifier, the circuit board comprising: signal generation means operable to generate first and second digital RF signals in dependence upon data to be transmitted, the first digital RF signal being a pre-distorted version of the second digital RF signal; first DAC means operable to convert the first digital RF signal into a first analogue RF signal for input to the amplifier to generate said amplified transmission signal; second DAC means operable to convert the second digital RF signal into a second analogue RF signal; and an error-signal generator, operatively connectable to the antenna and operatively connected to the second DAC means, for producing an error signal in dependence upon a difference between the transmission signal and the second analogue RF signal, wherein said signal generation means is operatively connected to the error-signal generator to control generation of said first digital RF signal in dependence upon said error signal so as to tend to reduce said difference. Preferably, the signal generation means and the first and second DAC means are provided together on a single IC chip mounted on said circuit board (or as IC chips of a chipset mounted on the circuit board).

There is disclosed herein an RF transmission method, comprising: generating first and second digital RF signals in dependence upon data to be transmitted, the first digital signal being a pre-distorted version of the second digital signal; converting the first digital RF signal into a first analogue RF signal; converting the second digital RF signal into a second analogue RF signal; producing an amplified transmission signal in dependence upon the first analogue RF signal; transmitting said amplified transmission signal; producing an error signal in dependence upon a difference between the transmission signal and the second analogue RF signal; and controlling generation of said first digital RF signal in dependence upon said error signal so as to tend to reduce said difference.

There is disclosed herein a method for use in an IC chip or chipset of an RF transmitter, the RF transmitter comprising an amplifier, an antenna operatively connected to said amplifier for transmitting an amplified transmission signal output by said amplifier, and an error-signal generator operatively connected to the antenna for producing an error signal in dependence upon a difference between the transmission signal and another signal, the method comprising: generating first and second digital RF signals in dependence upon data to be transmitted, the first digital RF signal being a pre-distorted version of the second digital RF signal; converting the first digital RF signal into a first analogue RF signal for input to the amplifier to generate said amplified transmission signal; converting the second digital RF signal into a second analogue RF signal for input to the error-signal generator as said other signal; and controlling generation of said first digital RF signal in dependence upon said error signal so as to tend to reduce said difference.

There is disclosed herein a method for use in a circuit board of an RF transmitter, the RF transmitter comprising an amplifier and an antenna operatively connected to said amplifier for transmitting an amplified transmission signal output by said amplifier, the method comprising: generating first and second digital RF signals in dependence upon data to be transmitted, the first digital RF signal being a pre-distorted version of the second digital RF signal; converting the first digital RF signal into a first analogue RF signal for input to the amplifier to generate said amplified transmission signal; converting the second digital RF signal into a second analogue RF signal; producing an error signal in dependence upon a difference between the transmission signal and the second analogue RF signal; and controlling generation of said first digital RF signal in dependence upon said error signal so as to tend to reduce said difference.

It will of course be appreciated that preferred features of apparatus aspects (RF transmitter, IC chip or chipset, and circuit board) of the present invention apply equally to method aspects of the present invention, and vice versa.

Reference will now be made, by way of example, to the accompanying drawings, of which:

Figure 1, mentioned above, is a schematic diagram of a previously-considered RF transmitter 1;
Figure 2, mentioned above, is a simplified schematic diagram 100 of RF transmitter 1;
Figure 3A, mentioned above, is a table showing a number of low-order intermodulation products;
Figure 3B, mentioned above, presents a typical spectrum of odd-order intermodulation products;
Figure 4, mentioned above, is a graph for explaining the concept of the third-order intercept point (IP3);
Figure 5 is a schematic diagram of an RF transmitter 500;

Figure 6 is a simplified schematic diagram 600 of RF transmitter 500;

Figure 7 shows the frequency spectrum of the output signal IFTS(IDEAL) output by DAC 4B;

Figure 8 is a schematic diagram of an RF transmitter 800;

Figure 9 shows the frequency spectrum of the output signal RFTS(IDEAL) output by DAC 830;

Figure 10 is a graph illustrating how an offset of the closest spurious component from RF band edges varies with the conversion frequency of the DAC;

Figure 11 is a schematic diagram of an RF transmitter 1100;

Figure 12 is a schematic diagram of an RF transmitter 1200;

Figure 13 is a schematic diagram of an RF transmitter 1300;

Figure 14 is a schematic diagram of an RF transmitter 1400;

Figure 15A is a block diagram of a DAC employed in its normal use;

Figure 15B is a simplified circuit schematic corresponding to Figure 15A;

Figure 15C is a block diagram of a DAC employed as a mixed-signal mixer;

Figure 15D is a simplified circuit schematic corresponding to Figure 15C; and

Figure 16 is a schematic diagram 1600 presenting one way of implementing the error-signal generator of embodiments of the present invention.

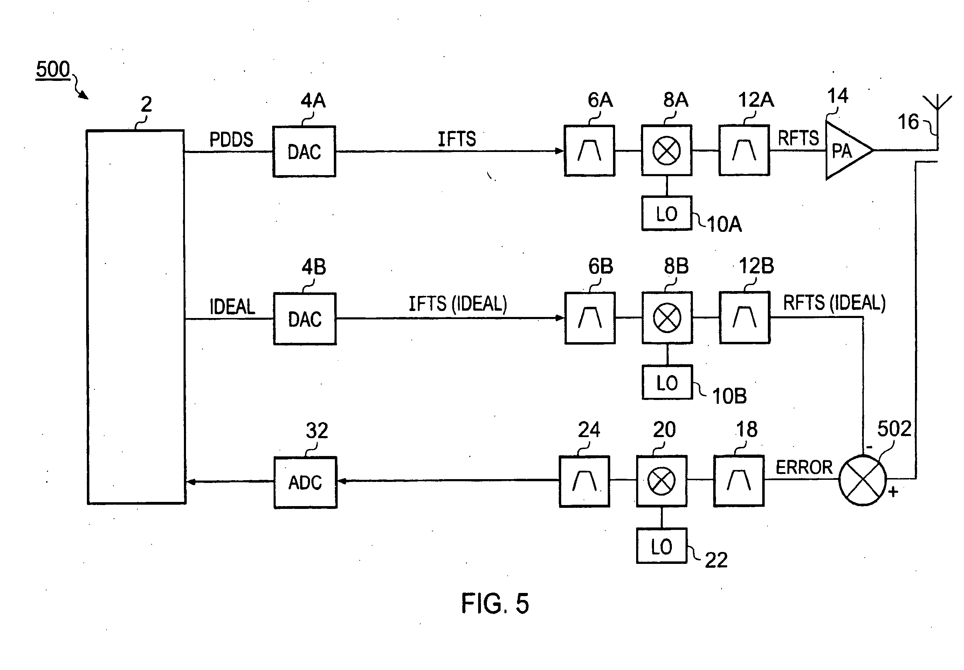

Figure 5 is a schematic diagram of an RF transmitter 500 not directly embodying the present invention, but useful for understanding embodiments thereof. RF transmitter 500 comprises similar elements to RF transmitter 1, and accordingly those elements are numbered in a similar way.

The main difference between RF transmitter 500 and RF transmitter 1 is a change in architecture. RF transmitter 500 has two similar transmit paths; an upper path in which references for the elements have been give the suffix "A", and a lower path in which like elements have the same references as for the upper path, except with the suffix "B".

The upper transmit path is a pre-distortion path and is therefore the same as the transmit path for RF transmitter 1. Accordingly, digital pre-distortion section 2 outputs a digital pre-distorted data signal PDDS, this PDDS signal is converted to an analogue intermediate-frequency transmit signal IFTS by DAC 4A, and this IFTS signal is frequency up-converted (by mixer 8A and local oscillator 10A) to form an analogue RF transmit signal RFTS. The lower transmit path is an "ideal" path. That is, the intended digital data signal (i.e. not subject to pre-distortion) IDEAL is output to DAC 4B. Similarly to the upper transmit path, this IDEAL signal is converted to an analogue intermediate-frequency transmit signal IFTS(IDEAL) by DAC 4B, and this IFTS(IDEAL) signal is frequency up-converted (by mixer 8B and local oscillator 10B) to form an analogue transmit signal RFTS(IDEAL).

It will be appreciated that signals RFTS and RFTS(IDEAL) are equivalent to one another except that the former is pre-distorted compared to the latter. Signal RFTS is amplified by power amplifier 14 and transmitted from antenna 16.

Another feature of the architecture of RF transmitter 500 which is different to that of RF transmitter 1 is that the output of the two transmit paths are compared to one another to generate an error signal indicative of a difference between those signals. In order to carry out such comparison, RF transmitter 500 comprises an error-signal generator 502, which may be considered to be a subtractor.

The signal transmitted by antenna 16 is coupled to the positive input of error-signal generator 502, and signal RFTS(IDEAL) is coupled to the negative input of error-signal generator 502. It will therefore be appreciated that the error signal output from the error-signal generator 502 is indicative of, in the absence of any pre-distortion, the distortion suffered in the upper transmit path as compared to that in the lower path (i.e. mainly that suffered in the power amplifier 14). With pre-distortion applied, it will be appreciated that the error signal is instead indicative of the effectiveness of the pre-distortion in linearizing the operation of the power amplifier 14, given that if the pre-distortion is perfect, the signals received at the inputs of the error-signal generator 502 should be identical.

Accordingly, the error signal is (in the feedback path of RF transmitter 500) frequency down-converted (by mixer 20 and local oscillator 22) and digitized by ADC 32 for use by digital pre-processing section 2 to control the pre-distortion applied to the intended signal IDEAL to generate signal PDDS.

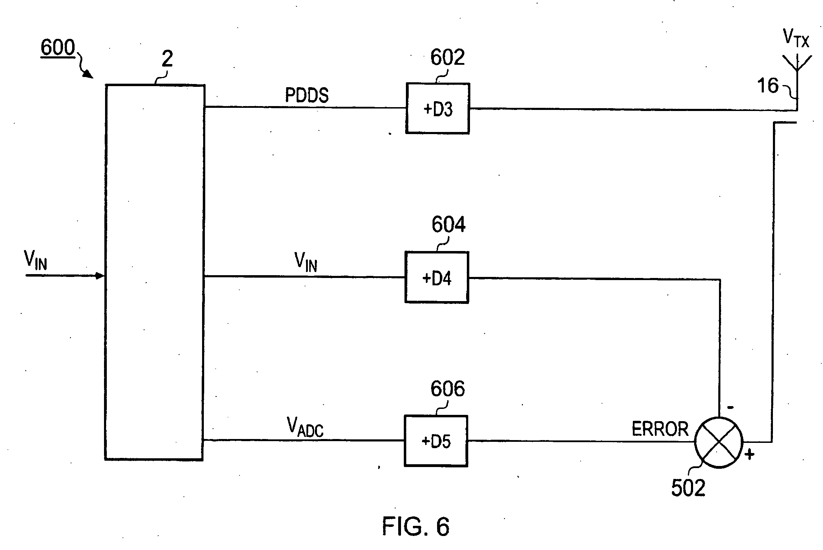

Figure 6 is a simplified schematic diagram 600 of RF transmitter 500, for use in appreciating the limitations of RF transmitter 500 in a similar way as appreciated of RF transmitter 1 through a consideration of Figure 2.

Like RF transmitter 500, schematic diagram 600 comprises digital pre-processing section 2, antenna 16, and error-signal generator 502. The components of the upper transmit path from digital pre-processing section 2 to antenna 16 have been represented by a single block 602 which adds distortion D3 to a signal passing therealong. The components of the lower transmit path from the digital pre-processing section 2 to error-signal generator 502 have been represented by a single block 604 which adds distortions D4 to a signal passing therealong. Finally, the components of the feedback path from error-signal generator 502 back to digital pre-processing section 2 have been represented by a single block 606 which adds distortion D5 to a signal passing therealong.

As can be seen from Figure 6, the digital pre-processing section 2 receives an intended digital data signal $V_{IN}$ and outputs: a pre-distorted digital data signal PDDS based thereon to the upper transmit path; and the intended signal $V_{IN}$ itself to the lower transmit path. The antenna 16 transmits an analogue RF signal $V_{TX}$ based upon the pre-distorted digital data signal PDDS. The error-signal generator receives signal $V_{TX}$ and an analogue RF signal based upon signal $V_{IN}$, and outputs an analogue error signal ERROR being a difference between those received signals. The digital pre-processing section 2 receives a digital feedback signal $V_{ADC}$ (which may be considered to be the output of the ADC 32 of Figure 5) based upon the analogue error signal ERROR.

Based on Figure 6, it can therefore be seen that:

$$V_{TX} = PDDS + D3$$

$$ERROR = V_{TX} - (V_{IN} + D4)$$

$$V_{ADC} = ERROR + D5$$
$$= PDDS + D3 - V_{IN} - D4 + D5$$

The pre-distortion performed in digital pre-processing section 2 of Figure 5 serves to adapt the pre-distorted digital data signal PDDS until the feedback signal $V_{ADC}$ reaches zero (i.e. until the feedback path is quiet), because at this point it appears to the digital pre-processing section 2 that the transmit path (including the power amplifier) has been effectively linearized. It will of course be appreciated that, in practice, it is not possible to achieve perfect pre-distortion (i.e. linearization), however for the benefit of further explanation it can be seen that at the point of "perfect" linearization:

$$V_{ADC} = 0$$

so that:

$$PDDS + D3 - V_{IN} - D4 + D5 = 0$$

Accordingly, at the point where the digital pre-processing section appears to have linearized the upper transmit path, it can be seen that:

$$PDDS = V_{IN} - D3 + D4 - D5$$

and therefore that:

$$V_{TX} = PDDS + D3$$
$$= V_{IN} + D4 - D5$$

In fact, at the point where $V_{ADC} = 0$, the error signal ERROR will also be zero, such that the distortion effect D5 may also be considered to be zero. Therefore, at the point where the digital pre-processing section 2 appears to have linearized the upper transmit path, it can be seen that:

$$V_{TX} = V_{IN} + D4$$

Accordingly, it can be seen that a fundamental feature of the Figure 5 architecture is that even if the pre-distortion performed by digital pre-processing section 2 is "perfect", the quality of the transmit signal $V_{TX}$ is limited by the distortion D4 generated by the components in the lower transmit path. Importantly, this is different to the Figure 1 architecture. The pressure is shifted from the feedback path to the lower transmit path, which alleviates pressure otherwise placed on components in the feedback path, i.e. the mixer, local oscillator, filters and ADC in that path.

Focussing on the feedback path of the Figure 5 architecture, because the distortion in that path is no longer the limit on the performance of RF transmitter 500, that path need not have an IIP3 as high as 30 dBm, and may instead only have an IIP3 of around 15 dBm. Like the RF transmitter 1, the power amplifier 14 of RF transmitter 500 is still driven close to its IIP3 in order to reduce mains power consumption, and therefore both 3rd and 5th order distortion components (at least) are significant. Accordingly, the components in the feedback path must still have the capability to process and ultimately sample (e.g. in the ADC) the 5th order distortion components, but the requirements placed on those components themselves in terms of the distortion they generate is now relaxed as compared to the corresponding components in RF transmitter 1. Consequently, the mixer in the feedback path can have a relatively low IIP3 of around 15 to 20 dBm enabling it to be a less expensive, less power hungry device than in RF transmitter 1. Only one frequency down-conversion stage is required in the feedback path (i.e. only one mixer and local oscillator pair) because the once-down-converted error signal can be input to ADC 32. Also, the ADC 32 in the feedback path of RF transmitter 500 need not have as high distortion performance as in RF transmitter 1, for example it could be an 8-bit, 375 MSa/s device, or a 6-bit, 1.5 GSa/s device. A further benefit of the Figure 5 architecture is that because the mixer in the feedback path can have a low IIP3, it can more readily be implemented in small-geometry CMOS and be integrated on-chip with the DACs, ADC and digital pre-processing section. Accordingly, from the point of view of the feedback path, it can be appreciated that RF transmitter 500 is preferable to RF transmitter 1.

Focussing instead on the lower transmit path of the Figure 5 architecture, because the distortion in that path is now the limit on the performance of RF transmitter 500, it can be appreciated that the Figure 5 architecture is in that respect less favourable than the Figure 1 architecture, for the following reasons.

DAC 4B (similarly to DAC 4A) receives a digital intermediate-frequency signal IDEAL and outputs an analogue intermediate-frequency transmit signal IFTS(IDEAL). For the benefit of further explanation, the wanted signal IFTS(IDEAL) may for example, have a bandwidth of 100 MHz and be centred around 300 MHz. Further, the DAC 4B may, for example, be a 1 GSa/s device.

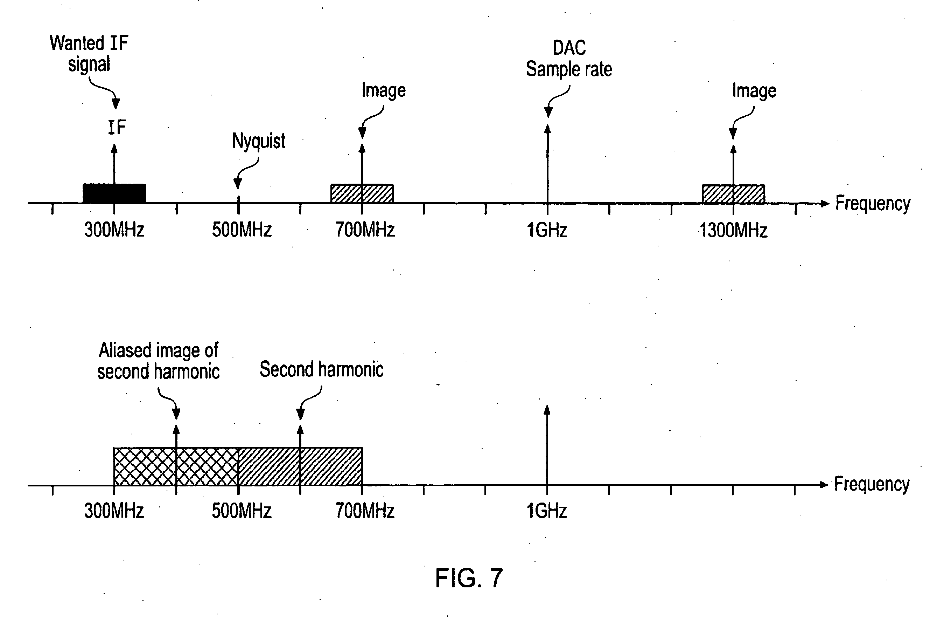

Figure 7 represents the frequency spectrum of the output signal IFTS(IDEAL) output by DAC 4B in the above example case. Although two spectrum plots are shown, they are in fact intended to be parts of the same plot and are shown separately merely for clarity.

Accordingly, the wanted IF signal can be seen as a 100 MHz channel centred around 300 MHz. The DAC functions partly as a mixer, and thus images of the wanted IF signal can be seen at 300 MHz above and below the sample rate of the DAC, 1 GHz, i.e. at 1300 MHz and 700 MHz, respectively. Other images will be produced, however these have not been shown for clarity.

The DAC 4B also outputs harmonics of the wanted IF signal and, again for clarity, only the second harmonic is shown, centred around twice the IF frequency, i.e. around 600 MHz. The second harmonic is spread over twice the bandwidth of the wanted IF signal, i.e. from 500 MHz to 700 MHz. The second harmonic is also aliased about the Nyquist frequency of the DAC, i.e. about 500 MHz. Accordingly, an image of the second harmonic appears from 300 MHz to 500 MHz, centred around 400 MHz.

It will be appreciated that the aliased image of the second harmonic overlaps in frequency with the wanted IF signal. This overlap is a cause of distortion in the wanted signal IFTS(IDEAL), because part of the aliased image of the second harmonic will fall into the passband of filter 6B and, following frequency up-conversion, filter 12B. Such overlap of an image of the wanted signal with the actual wanted signal can of course be avoided by frequency planning during design of the RF transmitter. However, the need to perform such careful frequency planning renders RF transmitter 500 complex to design and therefore unattractive.

Even if such frequency planning is carried out to prevent image overlap with the wanted IF signal IFTS(IDEAL), the DAC 4B generates intermodulation distortion products similarly to power amplifier 16. These intermodulation products appear close in to the spectrum of the wanted IF signal IFTS(IDEAL) as distortion. Therefore (similarly to the feedback path of RF transmitter 1), the lower transmit path in RF transmitter 500 must have a high IIP3, in order to enable the RF transmitter to have satisfactory distortion performance. Effectively, what is required is a steep IF filter 6B, a high IIP3 mixer 8B and local oscillator 10B, and a steep RF filter 12B. Again (as with RF transmitter 1), the high IIP3 analogue components (particularly the mixers and local oscillators) are not compatible with small-geometry CMOS technology and must be implemented as external components with their own power supplies and other driving circuitry. Further, in addition to the high specification requirements and difficulty in integration of the elements of RF transmitter 500, a number of those components must be changed when the band of transmission is changed. Typically, some or all of the analogue mixers and local oscillators, the filters and the power amplifier will need to be changed when the band of transmission is changed. As with RF transmitter 1, this gives rise to multiple sets of analogue components which are switched in and out of circuit depending on the band of transmission, which unfortunately leads to high complexity and cost being associated with RF transmitter 500.

Comparing RF transmitter 500 with RF transmitter 1, in deciding which is preferable it can be seen that a comparison can be made between the requirement to have a high IIP3 DAC and mixer in the lower transmit path of RF transmitter 500 or a high IIP3 ADC and set of mixers in the feedback path of RF transmitter 1. Both RF transmitters are realisable from this point of view, and therefore RF transmitters 1 and 500 may be considered comparable with one another from this point of view. In practice, RF transmitter 1 may be considered preferable to RF transmitter 500 as it has a lower component count, which leads to a lower cost transmitter and a simpler transmitter to design.

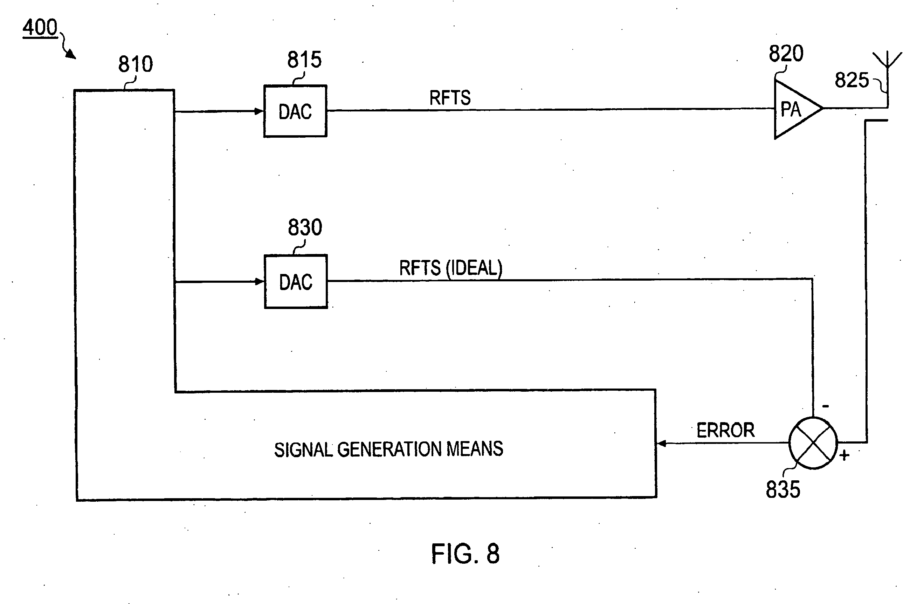

Figure 8 is a schematic diagram of an RF transmitter 800 embodying the present invention. RF transmitter 800 comprises a signal generation means 810, a first DAC 815, a power amplifier 820, an antenna 825, a second DAC 830, and an error-signal generator 835.

DAC 815 and power amplifier 820 are connected in series between signal generation means 810 and antenna 825. The signal transmitted by antenna 825 is coupled to an input of error-signal generator 835. DAC 830 is connected between signal generation means 810 and another input of error-signal generator 835. The output of error-signal generator 835 is input to the signal generation means 810.

In the present embodiment, and in the embodiments described hereinafter, the error-signal generator is a subtractor, however it will be appreciated that the error-signal generator could be implemented using other components. Accordingly, as shown in Figure 8, the signal transmitted by antenna 825 is coupled to the positive input, the output of DAC 830 is input to the negative input, and the output of the error-signal generator 835 (the difference between its inputs, or a signal dependent thereon) is input to the signal generation means 810.

It will be appreciated that the architecture of RF transmitter 800 is similar to that of RF transmitter 500. That is, RF transmitter 800 has upper and lower transmit paths, and a feedback path carrying an error signal. Accordingly, like the digital pre-processing section 2 of Figure 5, the signal generation means 810 is operable to output a pre-distorted digital data signal to DAC 815. DAC 815 is operable to convert that digital signal to an analogue signal for eventual amplification by power amplifier 820, and transmission by antenna 825. Also like the digital pre-processing section 2 of Figure 5, the signal generation means 810 is operable to output a digital signal to DAC 830 which is a non-pre-distorted version of the pre-distorted digital data signal output to DAC 815. Put another way, the signal output to DAC 830 may be considered to be an intended or ideal signal, and the signal output to DAC 815 may be considered to be a pre-distorted version of the ideal signal output to DAC 830.

The DAC 830 is operable to convert the ideal digital signal into an ideal analogue signal for eventual input into the negative input of the error-signal generator 835. Accordingly, the output signal of the error-signal generator 835 is an error signal indicative of an error between the amplified analogue signal transmitted by antenna 825 and the "ideal" analogue signal received from DAC 830. Because the signal path of the pre-distorted signal differs from the signal path of the ideal signal only by the presence of the power amplifier 820 (and antenna 825), the error signal is indicative (in the absence of pre-distortion) of the distortion in the power amplifier 820, or (given the pre-distortion) of the effectiveness of the pre-distortion carried out by the signal generations means 810. The signal generation means 810 controls the pre-distortion applied to the intended digital data signal in dependence upon the error signal received from error-signal generator 835. In this way, it is possible to effectively linearize the operation of the power amplifier 820.

Accordingly, it will be appreciated that a number of similarities exist between the RF transmitters 800 and 500. They have similar architectures to one another and therefore operate in the same overall manner. Like RF transmitter 500, the upper transmit path of RF transmitter 800 is a "pre-distorted" path, and the lower transmit path is an "ideal" path. Also, like RF transmitter 500, the critical path in terms of overall distortion performance in RF transmitter 800 is the lower (ideal) transmit path, and not the feedback path carrying the error signal. Accordingly, components in the feedback path of RF transmitter 800 (which are part of the signal generation means 810 and are therefore not individually shown in Figure 8) can have a relatively low IIP3 (as compared to the corresponding components in RF transmitter 1) and therefore tend to be compatible with small-geometry CMOS technology and as such integrateable on-chip. Like the RF transmitter 1, the power amplifier 820 of RF transmitter 800 is still driven close to its IIP3 in order to reduce mains power consumption, and therefore both 3rd and 5th order distortion components (at least) are significant. Accordingly, components in the feedback path must still have the capability to process and ultimately sample the 5th order distortion components, but the requirements placed on those components themselves in terms of the distortion they generate is relaxed as compared to corresponding components in RF transmitter 1, as in RF transmitter 500. Overall, the signal generation means 810 requires simpler, cheaper, less power-hungry components (in the feedback path) than the signal generation means 34. For example, if signal generation means 810 comprises an ADC to digitize the error signal, or a signal derived therefrom, that ADC may be, for example, an 8-bit, 375 MSa/s, or a 6-bit, 1.5 GSa/s device.

The main difference between the RF transmitter 800 and the RF transmitter 500 relates to the two transmit paths. By comparing Figure 8 with Figure 5, it will be appreciated that the transmit paths of RF transmitter 800 do not have any analogue frequency up-conversion components (mixers and local oscillators) or related filters. There are many design considerations and benefits associated with this difference, as will become apparent.

DACs 815 and 830 are both RF DACs; the signal generation means 810 is operable to provide digital RF signals as their input signals, and they are each operable to output analogue RF signals directly, in dependence upon their respective input signals. By way of example, whereas DACs 4A and 4B are operable to output IF analogue signals at around 300 MHz, DACs 815 and 830 are operable to output RF analogue signals at around 3 GHz, i.e. a factor of 10 higher in frequency.

One benefit of this ability to output analogue RF signals directly is that the need for analogue IF components in the transmit paths is removed. Looking back at Figure 5, it can be seen that the need for analogue IF filters 6A and 6B, analogue mixers 8A and 8B and associated local oscillators 10A and 10B is now removed in RF transmitter 800. There is no need to frequency up-convert analogue IF signals to RF. The need for RF filters 12A and 12B is also removed as will now be appreciated.

As with RF transmitter 500, frequency planning may be carried out in respect of RF transmitter 800 to limit distortion in the transmit paths. It will be recalled that distortion in the lower transmit path (the "ideal" transmit path) is critical as concerns the overall distortion performance of RF transmitters of this architecture.

By way of example, DAC 830 may be considered to receive a digital RF signal "IDEAL" and to output a wanted analogue RF signal RFTS(IDEAL), the digital RF signal IDEAL being arranged to cause the wanted analogue RF signal RFTS(IDEAL) to have, for example, a channel bandwidth of 20 MHz centred around 2.5 GHz. Further, DAC 4B may, for example, be a 12 GSa/s device. Although the DAC 4B is considered to be a 12 GSa/s device by way of example, it will later be appreciated that this sampling rate is particularly advantageous.

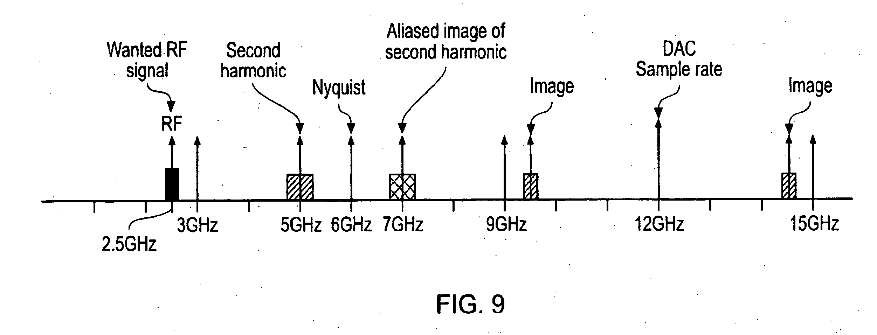

Figure 9 represents the frequency spectrum of the output signal RFTS(IDEAL) output by DAC 830 in the above example case. In order to compare the frequency planning for RF transmitter 800 with that for RF transmitter 500, the frequency spectrum of Figure 9 has been prepared similarly to that of Figure 7.

Accordingly, the wanted RF signal can be seen in Figure 9 as a 20 MHz channel centred around 2.5 GHz. It is emphasised that the bandwidths of the signal and images shown in Figure 9 are not to scale, and are enlarged for clarity. Images of the wanted RF signal can be seen at 2.5 GHz above and below the sample rate of the DAC, 12 GHz, i.e. at 14.5 GHz and at 9.5 GHz, respectively. Other images will be produced, however these have not been shown for clarity.

The DAC 830 also outputs harmonics of the wanted RF signal and, again for clarity, only the second harmonic is shown, centred around twice the RF frequency, i.e. around 5 GHz. The second harmonic is spread over twice the bandwidth of the wanted RF signal. The second harmonic is also aliased about the Nyquist frequency of the DAC, i.e. about 6 GHz. Accordingly, an image of the second harmonic appears centred around 7 GHz. It will be appreciated that the third harmonic (although not shown) would be centred around 7.5 GHz, and be spread over three times the bandwidth of the wanted RF signal. Further, the third harmonic would also be aliased about the Nyquist frequency of the DAC, i.e. about 6 GHz. Accordingly, an image of the third harmonic would appear centred around 4.5 GHz.

It will be appreciated that because the sample rate of DAC 830 is substantially high (i.e. over a factor of 10 higher than for DAC 4B), the various images are distantly spread apart in frequency, and the chance of images and harmonics of the wanted RF signal overlapping in frequency with the wanted RF signal itself is low. That is, only modest frequency planning is required in the RF transmitter 800. Further, the results of the frequency planning can be implemented digitally, i.e. in software, because the parameters of the wanted analogue RF signal are defined by the digital RF signal from which it is generated.

Because the various images and harmonics of the wanted analogue RF signal are distantly spread from the wanted RF signal in the frequency spectrum, the necessity for a steep RF filter following the DAC output is relaxed. That is, it is possible to have a reasonably cheap, inexpensive RF filter following the DAC output (i.e. its transfer characteristic does not need to be steep) and it is even possible to have no RF filter following the DAC, as in Figure 8. If DAC 815 is the same as DAC 830 (which is preferable from a system design point of view, but not essential), then in the upper transmit path it is possible to rely on the internal RF filtering of the power amplifier 820. Such internal RF filtering can be relatively low performance (because the unwanted images are distantly spread from the wanted signal) and will serve to attenuate the out-of-band transmission signal components to meet overall system out-of-band distortion requirements.

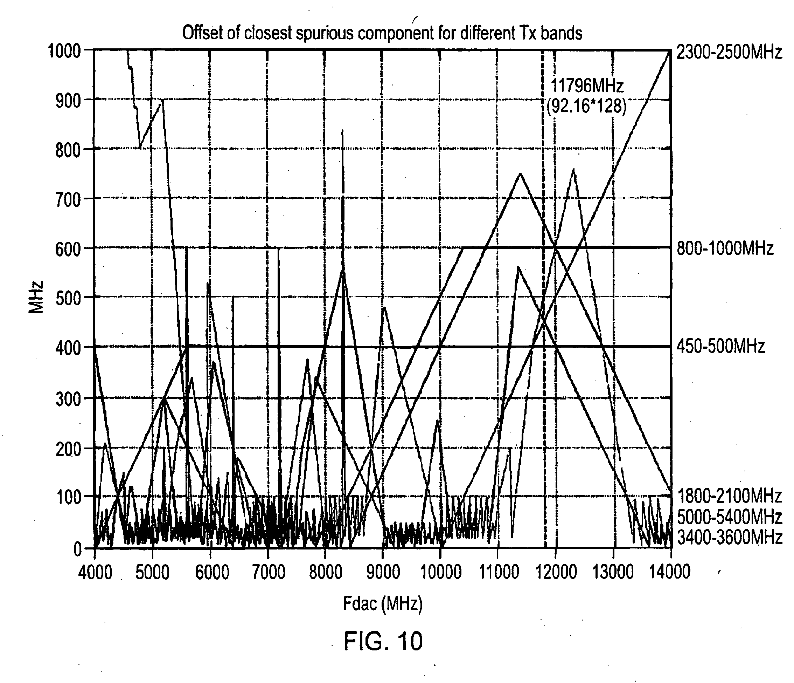

As previously mentioned, the sample rate of the DAC 830 (and preferably also the DAC 815) is advantageously around 12 GSa/s. Figure 10 is a graph which illustrates, for each of the common RF frequency bands (450 to 500, 800 to 1000, 1800 to 2100, 2300 to 2500, 3400 to 3600, and 5000 to 5400 MHz bands), how an offset of the closest spurious component from the band edge varies as the conversion frequency of the DAC (for example DAC 815 and/or 830 in Figure 8) changes. It can be seen from the graph that at a conversion frequency $F_{DAC}$ = 11.796 GSa/s, the closest spurious component is more than 400 MHz away from all of the common RF frequency bands. This suggests that it should be possible to employ a single fixed reference clock (at about 12 GHz, or at about 6 or even 3 GHz if interleaving is employed) to operate at 12GSa/s, or more preferably at 11.796 GSa/s, irrespective of the intended one of the above RF frequency bands. As mentioned previously, the sample rate 11.79648 GSa/s is particularly advantageous as it is exactly a multiple (3072 times) of the commonly used base data rate of 3.84 MHz.

As can be appreciated, by using a sample rate of around 12 GSa/s in DAC 830 (and preferably DAC 815), the RF transmitter 810 becomes particularly flexible from a frequency-planning and system-design point of view. Different RF frequency bands can be selected in software in the digital part of RF transmitter 800, i.e. within signal generating means 810, and no other change is required in the RF transmitter 800, except possibly switching to a different power amplifier 820 for the selected RF frequency band. The need to have multiple sets of analogue components for the different RF frequency bands is removed, and true software radio is realised.

Yet a further advantage of the RF transmitter 800 is in terms of system integration. As previously mentioned, the components in the feedback path (included in signal generation means 810 and not shown individually in Figure 8), such as an ADC, mixer and local oscillator, can be low IIP3 components and can therefore be implemented in small-geometry CMOS technology. Further, DACs 815 and 830 can also be implemented in small-geometry CMOS technology. The result is that RF transmitter 800 can be implemented as a single chip, except for power amplifier 820, antenna 825 and error-signal generator 835. As will be appreciated later, error-signal generator 835 can be implemented as a resistor. Accordingly, it will be appreciated that compared to RF transmitters 1 and 500, RF transmitter 800 is a significant improvement in terms of system integration.

It will be recalled that the lower transmit path in RF transmitter 800 is critical in terms of overall system distortion performance. As explained with reference to Figure 6, even if the pre-distortion system works perfectly, the distortion present in the transmitted RF signal is dependent upon the distortion in the lower (ideal) transmit path. Examining Figure 8, it can be seen that DAC 830 is the only (or at least the only significant) component in this path, and so the distortion performance of the RF transmitter 800 depends almost entirely on the distortion performance of DAC 830. In effect, almost the entire distortion budget of the RF transmitter can be allocated to the DAC 830. It will be appreciated that DAC 830 will, like DAC 4B, generate intermodulation distortion components which thus affect the overall system distortion performance. DAC 830 (as exemplified above) outputs an RF signal with a frequency (e.g. 3 GHz) about 10 times larger than the IF signal (e.g. 300 MHz) output by DAC 4B. Thus, the internal distortion of DAC 830 (e.g. due to switching mismatches) must be about 10 times better than in DAC 4B in order to have acceptable performance. For example, if this were not the case the RF transmitter 800 could have 20dB worse distortion than in RF transmitter 500, which would be unacceptable in a commercial situation. As will be appreciated later, the commercially-required DAC performance has been achieved by the present inventors, thereby making RF transmitters embodying the present invention viable commercial products.

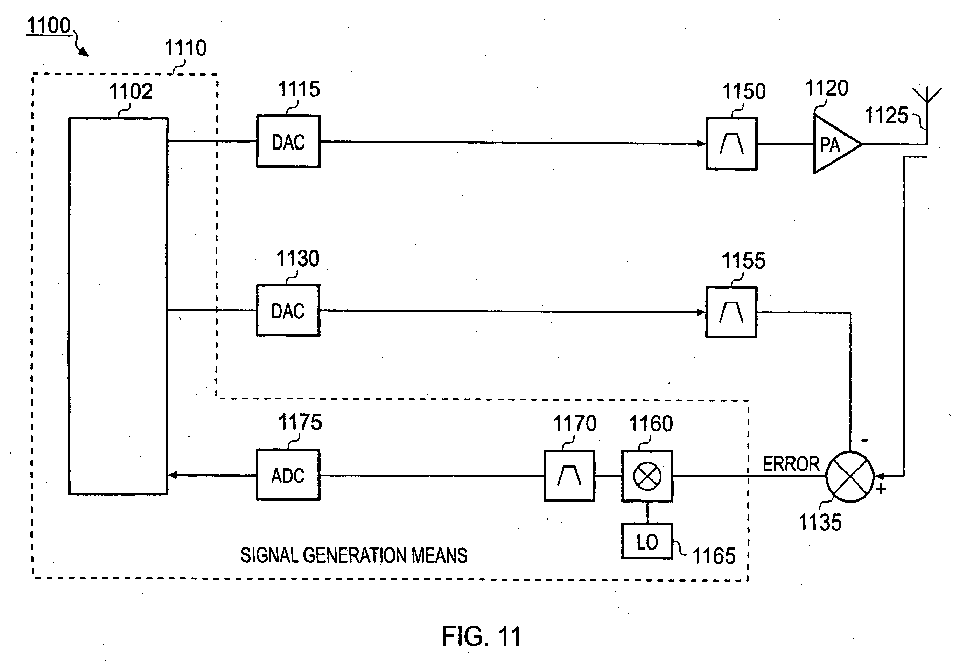

Figure 11 is a schematic diagram of an RF transmitter 1100 embodying the present invention. RF transmitter 1110, similar to RF transmitter 800, comprises a signal generation means 1100, a first DAC 1115, a power amplifier 1120, an antenna 1125, a second DAC 1130, and an error-signal generator 1130. RF transmitter 1100 further comprises filters 1150, 1155 and 1170, an ADC 1175, a digital pre-distortion section 1102, a mixer 1160 and a local oscillator 1165. As can be seen from Figure 11, the digital pre-distortion section 1102, the ADC 1175, the filter 1170, the mixer 1160, and the local oscillator 1165 form part of signal generation means 1110.

It will be appreciated that the RF transmitter 1100 is similar to the RF transmitter 800. Accordingly, only the differences between those transmitters will be described herein.

Filter 1150 is connected in series between DAC 1115 and power amplifier 1120. Filter 1155 is connected in series between DAC 1130 and the negative input of error-signal generator 1135. Those filters are RF filters and may be low-spec filters as mentioned in respect of Figure 8. They may also be omitted as in RF transmitter 800, and are therefore only included in RF transmitter 1100 to show that they may be included. Mixer 1160, filter 1170, and ADC 1175 are connected in series between the output of the error-signal generator 1135 and the digital pre-processing section 1102. Local oscillator 1165 is connected to mixer 1160.

DAC 1115 and DAC 1130 serve the same basic purpose as DAC 815 and DAC 830, respectively. DAC 1115 receives a pre-distorted digital data signal from digital pre-processing section 1102, and converts that signal into an RF analogue signal for filtering by filter 1150, amplification by power amplifier 1120 and transmission by antenna 1125. DAC 1130 receives an "ideal" undistorted digital data signal from digital pre-processing section 1102, and converts that signal into an RF analogue signal for filtering by filter 1155 and for input to the negative terminal of error-signal generator 1135.

The error signal output by error-signal generator 1135 is frequency down-converted by mixer 1160 and local oscillator 1165, filtered by filter 1170 and input to ADC 1175. That error signal, being an RF analogue signal, may be thereby down-converted to an IF or baseband analogue signal.

ADC 1175 digitizes the down-converted error signal for use by the digital pre-distortion section 1102 in controlling the pre-distortion applied to the "ideal" (intended) digital data signal to generate the pre-distorted digital data signal input to DAC 1115, thereby to tend to linearize the operation of power amplifier 1120.

As will be appreciated through a comparison of Figure 11 with Figure 8, the RF transmitter 1100 is essentially equivalent to RF transmitter 800, except that components in the feedback path and the digital pre-processing section are explicitly shown. The upper and lower transit paths of RF transmitter 1100 are therefore essentially the same as those of RF transmitter 800 (filters 1150 and 1155 are optional), and further explanation of the benefits of those paths is omitted as the explanation above in respect of Figure 8 applies equally to Figure 11. DACs 1115 and 1130 may be 12GSa/s devices. The digital pre-processing section 1102 may be considered to be substantially the same as digital pre-processing section 2 of Figure 5, except that it is operable to output digital RF signals to DACs 1115 and 1130. The feedback path of RF transmitter 1100 may be considered to be substantially the same as the feedback path of RF transmitter 500, except that no RF filter equivalent to RF filter 18 is provided as it is not necessary due to the distantly spread images in the spectrum of the RF signals of RF transmitter 1100.

Accordingly, given that filters 1150 and 1155 may be omitted, and that the feedback components may be low IIP3 components, it can again be appreciated that RF transmitter may be implemented on a single small-geometry CMOS chip, except for power amplifier 1120, antenna 1125 and error-signal generator 1135. The software-radio features of RF transmitter 800 of course also apply to RF transmitter 1100.

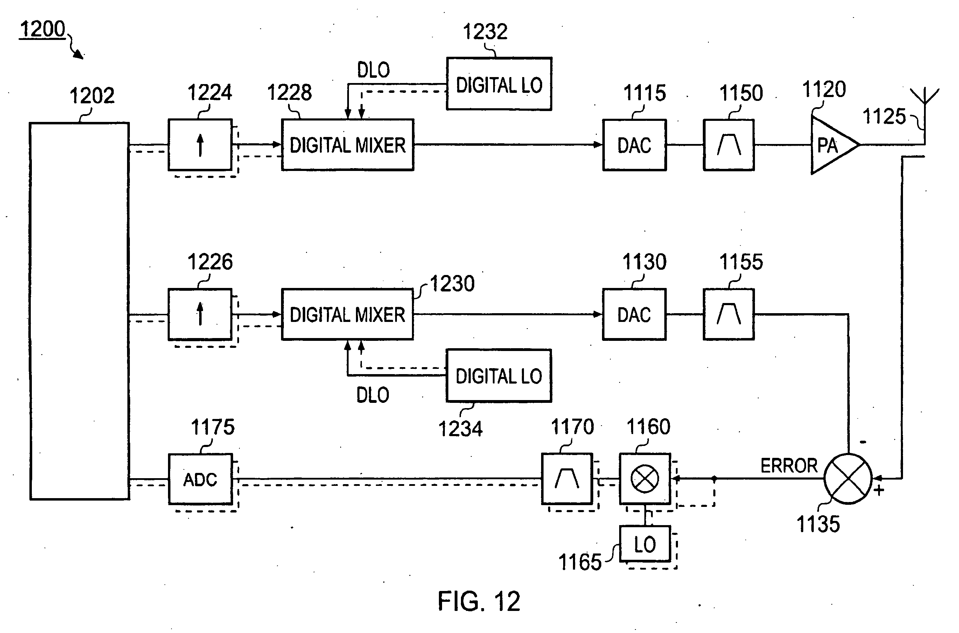

Figure 12 is a schematic diagram of an RF transmitter 1200 embodying the present invention. It will be appreciated that the architecture of RF transmitter 1200 is closely similar to that of RF transmitter 1100 discussed above, and accordingly the common elements are numbered the same. The difference between RF transmitter 1200 and RF transmitter 1100 is that RF transmitter 1200 comprises a digital pre-processing section 1202, digital interpolation units 1224 and 1226, digital mixers 1228 and 1230, and digital local oscillators 1232 and 1234. For the time being, the dashed lines in Figure 12, representing possible additional elements and signal lines, will be ignored. Those possible additional elements and signal lines will be considered later. As in Figure 11, RF filters 1150 and 1155 may be considered optional in RF transmitter 1200. It will be appreciated that digital oscillators 1232 and 1234 could be implemented as a single shared digital local oscillator.

Digital interpolation unit 1224 and digital mixer 1228 are connected in series between digital pre-processing section 1202 and DAC 1115. Similarly, digital interpolation unit 1226 and digital mixer 1230 are connected in series between digital pre-processing section 1202 and DAC 1130. Digital local oscillators 1232 and 1234 are connected to supply digital local oscillator signals (DLO) to digital mixers 1228 and 1230, respectively. Accordingly, the digital interpolation unit 1224, digital mixer 1228 and digital local oscillator 1232 together act as a digital up-conversion unit (DUC). Similarly, the digital interpolation unit 1226, digital mixer 1230 and digital local oscillator 1234 together act as another DUC. Digital mixers 1228 and 1230 may be operable to perform some digital modulation.

Digital pre-processing section 1202 outputs a digital baseband pre-distorted signal to digital interpolation unit 1224, and a digital baseband "ideal" signal to digital interpolation unit 1226. As before, the pre-distorted signal is a distorted version of the ideal signal. It can be therefore appreciated that digital pre-processing section 1202 is the same as digital pre-processing section 1102, except that it outputs digital baseband signals instead of digital RF signals.

As the pre-distorted signal passes from the digital pre-processing section 1202 to DAC 1115, it is digitally up-converted to a digital RF signal by the DUC in that path. As the "ideal" signal passes from the digital pre-processing section 1202 to DAC 1130, it is digitally up-converted to a digital RF signal by the DUC in that path.

Accordingly it can be seen that the signals input to DACs 1115 and 1130 in RF transmitter 12 are digital RF signals and are therefore essentially equivalent to the signals input to those DACs in RF transmitter 1103. Accordingly, it will be appreciated that RF transmitter 1200 functions in the same overall way as RF transmitter 1100 and has the same related advantages.

In an embodiment of the present invention, the pre-distorted and "ideal" digital baseband signals output by the digital pre-processing section 1202 may be complex (I/Q) baseband signals. In that case, digital mixers 1228 and 1230 may be digital I/Q complex mixers, and digital local oscillators 1232 and 1234 may be complex I/Q digital local oscillators. Further, elements in the two transmit paths from the digital pre-processing section 1202 will, in that case, need to be duplicated as indicated by the dashed lines in Figure 12. As shown in Figure 12, this effectively leads to a pair of digital interpolation units 1224A and 1224B in the upper transmit path instead of digital interpolation unit 1224, one for the I-component and the other for the Q-component digital baseband signal. Similarly, this effectively leads to a pair of digital interpolation units 1226A and 1226B in the lower transmit path instead of digital interpolation unit 1226, one for the I-component and the other for the Q-component digital baseband signal. As shown in Figure 12, the separate I and Q component signals for each path are received by the digital mixer in that path, that mixer also receiving I and Q component digital local oscillator signals from the digital local oscillator for that path.

The digital RF signals output by the digital mixers of each path are thus digital RF I/Q signals.

In the case of such complex signal transmission, duplication of elements is also required on the error-signal (feedback) path from the error-signal generator 1135 to the digital pre-processing section 1202, also as shown by dashed lines in Figure 12. Accordingly, a pair of mixers 1160A and 1160B, a pair of local oscillators 1165A and 1165B, a pair of filters 1170A and 1170B, and a pair of ADCs 1175A and 1175B are required. The local oscillators 1165A and 1165B should be 90 degrees out of phase from one another to cause the mixers 1160A and 1160B to generate the two complex components I and Q from the error signal such that the digital pre-processing section 1202 receives an error signal for the I component and an error signal for the Q component which it can use to control pre-distortion applied on the output I and Q components (output to digital interpolation units 1224A and 1224B) separately.

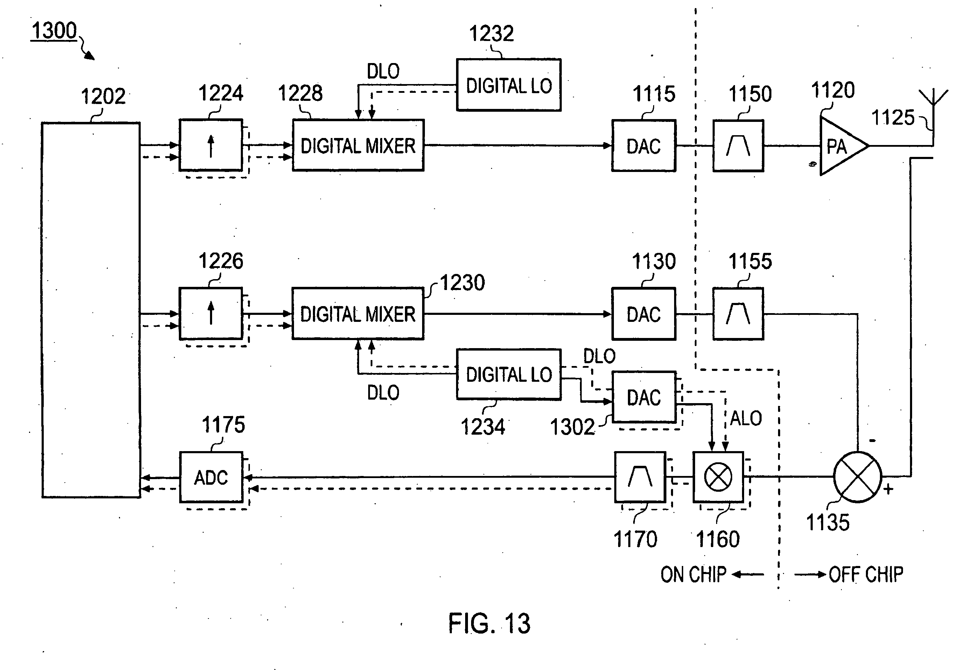

The mixer 1160 is assumed to be an analogue mixer, in which case an analogue local oscillator signal is required. Figure 13 is a schematic diagram of an RF transmitter 1300 embodying the present invention, in which such a required local oscillator signal is generated in a preferred manner.

RF transmitter 1300 is closely similar to RF transmitter 1200, and accordingly those parts in common between the two transmitters are numbered the same. Again, as shown in Figure 13 with dashed lines, it will be appreciated that complex transmission signals (I/Q) may be employed, and accordingly the various signal paths and elements may be duplicated. Again, it is to be understood that RF filters 1150 and 1155 are optional.

In RF transmitter 1300, a digital local oscillator signal (DLO) already present in digital local oscillator 1234, for up-converting a digital baseband signal to a digital RF signal, is employed to generate the necessary analogue local oscillator signal (ALO) for the mixer 1160. Accordingly, no separate local oscillator (1165 in Figure 12) is required in the RF transmitter 1300.

In the RF transmitter 1300, an additional DAC 1302 (or pair of DACs 1302A and 1302B in the case of I/Q signals) is provided, and is connected to receive the digital local oscillator signal and to convert that digital local oscillator signal into the required analogue local oscillator signal for input to the mixer 1160. DAC 1302 may be the same as DACs 1115 and 1130. As the digital local oscillator signal is employed by the digital mixer 1230 to convert a digital baseband signal to a digital RF signal, the analogue local oscillator signal generated by the DAC 1302 may be used by the mixer 1160 to down-convert the error signal output by the error-signal generator 1135 from an RF signal to a baseband signal.

The architecture of the RF transmitter 1300 is particularly advantageous because the analogue local oscillator signal necessary for the mixer 1160 can be generated digitally. The digital local oscillator signal may be generated by any part of the signal generation means (i.e. by any component, shown or not shown, to the left of DACs 1115 and 1130 in Figure 13), and need not necessarily be taken from digital local oscillator unit 1234. The frequency down-conversion performed by the mixer 1160 therefore can be effectively controlled in software. Furthermore, all of the elements of the RF transmitter 1300 to the left-hand side of the dotted line can (as already appreciated from previous embodiments) be provided on a single IC (integrated circuit) chip, only the components to the right-hand side needing to be provided separately. Accordingly, only the filters 1150 and 1155 need to be changed as radio transmission is transferred from one band to the next. It is re-emphasised that filters 1150 and 1155 may indeed be optional. Accordingly, the Figure 13 architecture can address broad multi-band multi-sector, multi-carrier radio requirements with a common platform, and can support all common RF bands. As a consequence, the Figure 13 architecture again enables software-defined radio to become realisable.

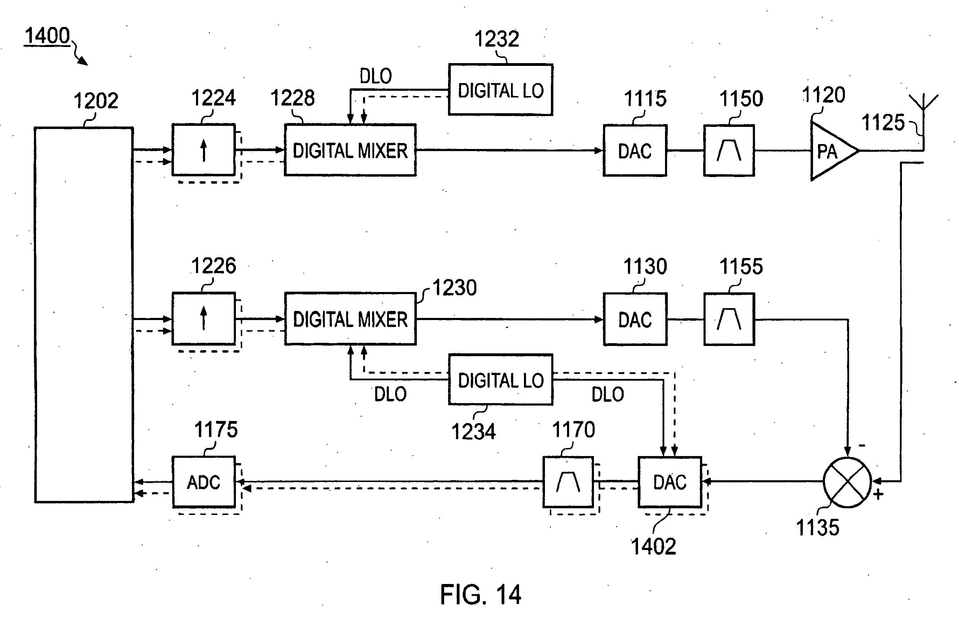

Figure 14 is a schematic diagram of an RF transmitter 1400 embodying the present invention. Like RF transmitter 1300, RF transmitter 1400 presents a preferred design for performing frequency down-conversion of the error signal output from error-signal generator 1135 from an RF signal to (in the present example) a baseband signal (or I/Q set of baseband signals).

RF transmitter 1400 is closely similar to RF transmitters 1200 and 1300, and accordingly those parts in common between the transmitters are numbered the same. Again, as shown in Figure 14, it will be appreciated that complex transmission signals (I/Q) may be employed, and accordingly the various signal paths and elements may be duplicated in Figure 14 as shown by dashed lines. Again, it is to be understood that RF filters 1150 and 1155 are optional.

By comparing Figure 14 with Figure 13, it can be seen that in RF transmitter 1400 the DAC 1302 and mixer 1160 have been replaced by a DAC 1402 (or pair of DACs 1402A an 1402B in the case of I/Q signals). DAC 1402 may be the same as DACs 1115 and 1130. DAC 1402 is connected in series between the output of error-signal generator 1135 and filter 1170, and serves as a mixed-signal mixer to down-convert the error signal output from error-signal generator 1135 from an RF signal to (in the present example) a baseband signal.

Accordingly, DAC 1402 is connected to receive the digital local oscillator signal from digital local oscillator 1234. As will be appreciated by analogy with Figure 13, DAC 1402 serves to down-convert the error signal from RF to baseband because the digital local oscillator signal is employed in digital mixer 1230 to convert a digital baseband signal to a digital RF signal.

The benefit of using DAC 1402 as a mixed-signal mixer is that no analogue mixer and local oscillator is required. The Figure 14 architecture has a fundamental linearity (IP3) advantage over the Figure 1 architecture because it removes all analogue IF elements and shifts frequency limitations from analogue component matching to benefits of digital calibration. Also, the circuit design for DACs 1115 and 1130 can be re-used for DAC 1402 leading to a simplification in overall system design and integration.

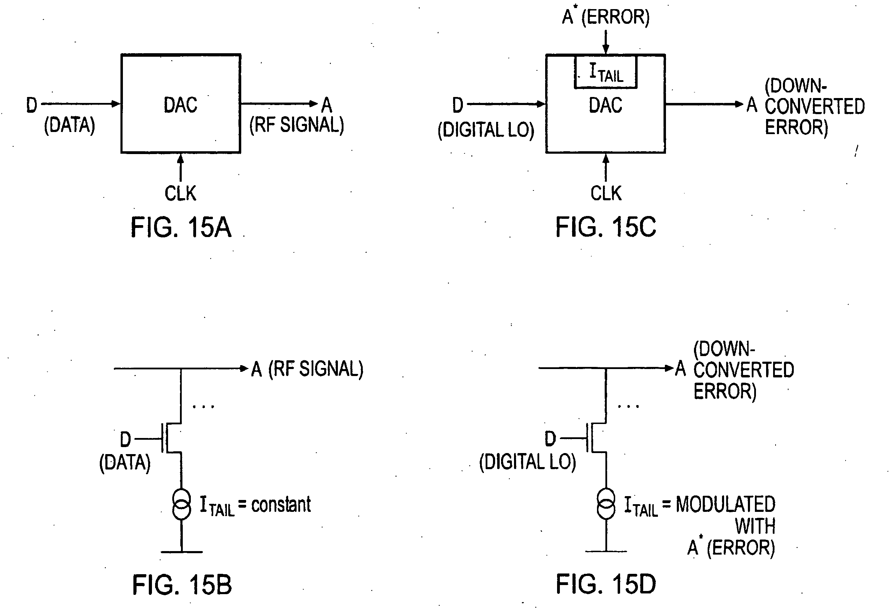

Figures 15A to 15D are schematic diagrams for the purpose of understanding the principle behind employing a DAC as a mixed-signal mixer.

Figure 15A is a block diagram of a DAC as it would be employed in its normal use, and Figure 15B is a simplified circuit schematic corresponding to Figure 15A. Looking at Figure 15A, in the normal use, the DAC receives a digital data signal D and a clock signal CLK, and outputs an analogue signal A, in the present case being an analogue RF signal. Looking at Figure 15B, the DAC may be a current switching type DAC in which a plurality of segments (only one is shown) may be switched in or out of connection to an output terminal (or between two output terminals in a differential DAC) in dependence on the digital signal D (which may be decoded before being applied to the switches of the segments). Accordingly, the current output as analogue signal A varies in magnitude with the digital signal D. In this case, the current $I_{TAIL}$ in each segment is constant.

Figure 15C is a block diagram of a DAC as it could be employed as a mixed-signal mixer, and Figure 15D is a simplified circuit schematic corresponding to Figure 15C. Looking at Figure 15C, the DAC still receives a clock signal CLK, but as its digital input signal it receives a digital local oscillator signal. The DAC also receives a further analogue signal A*, which in this case is the error signal output by the error-signal generator 1135. This signal A* is used to modulate the current $I_{TAIL}$ in each segment, as can be seen in Figure 15D. Accordingly, the output analogue signal A of the DAC now includes the required down-converted version of the error signal (and an up-converted version which can be filtered out by filter 1170).

It will be appreciated that in the case of differential DACs and I/Q complex signals, DAC 1402 could be implemented as pairs of DACs to provide balanced differential feedback paths.

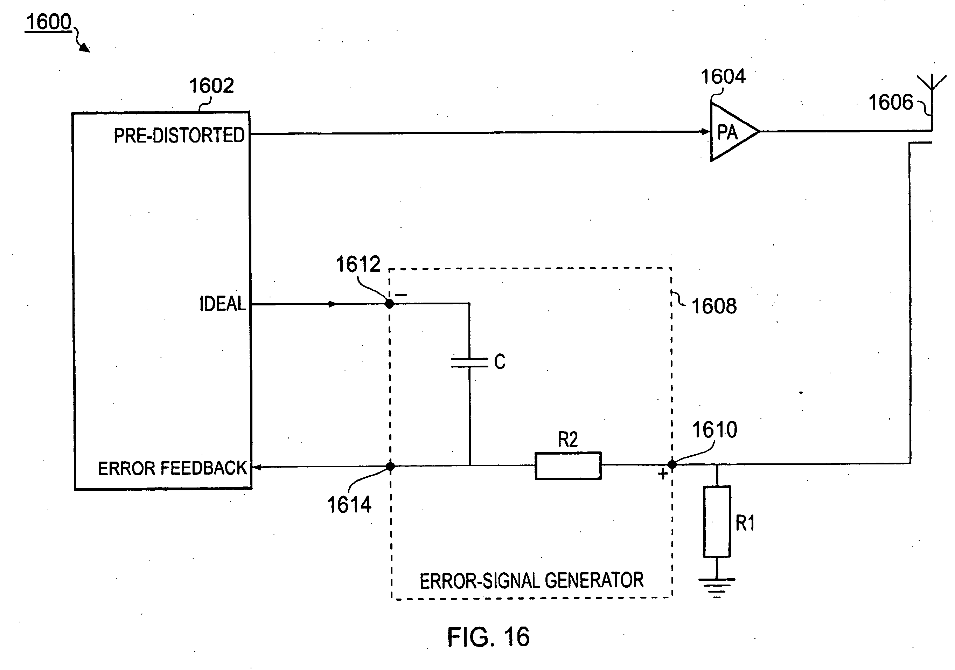

Figure 16 is a schematic diagram 1600 which presents one way of implementing the error-signal generator of embodiments of the present invention. For easy comparison with embodiments of the present invention, schematic diagram 1600 represents an entire RF transmitter. For simplicity, all components except the power amplifier 1604, the antenna 1606 and the error-signal generator 1608 are represented by block 1602.

Accordingly, block 1602 outputs a pre-distorted analogue signal to power amplifier 1604 for amplification and transmission by antenna 1606. That transmitted signal is coupled to an input path which feeds into positive input terminal 1610 of error-signal generator 1608. That input path is terminated by resistor R1 to ground. Resistor R1 may for example have a value of 50Ω.

Block 1602 also outputs an "ideal" analogue RF signal to a negative input terminal 1612 of error-signal generator 1608. The error signal output from the output terminal 1614 of error-signal generator 1602 is fed back to block 1602.

As can be seen from Figure 16, error-signal generator 1608 comprises a resistor R2 connected between its positive input terminal 1610 and its output terminal 1614, and a capacitor C connected between its negative input terminal 1612 and its output terminal 1614. Resistor R2 may for example have a value of 1kΩ.

The effect of this arrangement is that the coupled transmitted analogue RF signal fed to positive input terminal 1610 is stepped down in magnitude over resistor R2 and summed with the "ideal" analogue RF signal at the output terminal 1614 due to the presence of capacitor C. The values of R1 and R2 are chosen to cause the required step down in magnitude.

By effectively inverting the digital signal used to generate the "ideal" analogue RF signal, an effective negative input is created, so that the summing at the output terminal 1614 in actual fact is a subtraction of the non-inverted "ideal" analogue RF signal from the transmitted RF signal.

Accordingly, it will be appreciated that the RF transmitters embodying the present invention enable an integrated system board to be realised. The block 1602 can be a single small-geometry CMOS chip mounted on a system board with components R1, R2 and C. All that is required is an off-board connection to the power amplifier 1604 and the antenna 1606, and a return connection from the antenna 1606 back on-board to the positive input terminal 1610.

Digital up-conversion units, digital modulators, filters, subtractors, analogue mixers, and ADCs are known in the art. Accordingly, a detailed description of those individual elements is not provided herein. The predistortion technique is also well known in the art.

As previously mentioned, the DACs employed in embodiments of the present invention (particularly in the lower transmit path) may operate at 12 GSa/s and output RF signals directly at around 3 GHz.

US6992609 discloses high-speed DACs capable of operating at sample rates at and exceeding 12 GSa/s. Although for certain applications such DACs could be employed in embodiments of the present invention, those DACs suffer from significant internal distortion. The present inventors have accordingly addressed the problem of internal distortion in high-speed DACs, to provide preferred high-speed DACs, as follows.

In order to provide a viable commercial product, the internal distortion of such preferred high-speed DACs must be about 10 times better than in conventional IF DACs (i.e. which output IF signals at about 300 MHz), otherwise an RF transmitter embodying the present invention could have up to 20dB worse distortion performance than is commercially desirable. For example, such DACs need to have clock jitter and internal switching delay mismatches of a few tens of fs (femtoseconds), which was previously thought to be unachievable in practice.

In order to provide DACs with such substantially high distortion performance, the inventors have identified sources of distortion in previously-considered DAC technology and have developed improved DAC circuitry to substantially remove those sources of distortion. A number of those improvements are detailed below by reference to co-pending European patent applications (referenced by way of their publication numbers) filed by the applicant. Those co-pending applications are incorporated by reference into the present application, and copies of those co-pending applications were filed with the present application.

European patent publication EP2019427 discloses flip-chip packages and flip chips, in particular such flip-chip packages and flip chips in which an effect of noise on operational performance is substantially reduced. DAC circuitry may be implemented on such flip chips in order to enable the DAC circuitry to be provided on the same chip as other circuitry without noise from one substantially effecting the other, and/or to reduce noise from one part of such DAC circuitry affecting another part of such DAC circuitry.

European patent publication EP2023487 discloses switching circuitry for use in high-speed digital-to-analogue converters (DACs). In a differential switching circuit of a high-speed DAC, the switching transistors are required to switch from OFF to ON and vice versa very quickly. To achieve rapid switching, it is necessary for the transistors to be made as small as possible. However, although making the transistors as small as possible minimises their switching delays, it is found that the mismatch in switching delay from one transistor to another increases. Mismatch in switching delay is caused by random variations in the threshold voltages $V_{TH}$ of the transistors. Mismatch in switching delay can also arise from other variations between the transistors, including the gains of the transistors. The switching circuitry in this referenced application addresses the problem of mismatch in switching delay.

European patent publication EP2019487 discloses switching circuitry for use in high-speed digital-to-analogue converters (DACs), which addresses a further problem relating to switching delay mismatches. A DAC capable of operating at a high conversion frequency, for example around 12 GSa/s, imposes some severe requirements on switch driver circuitry employed therein. As will be appreciated from this referenced application, one way of relaxing these requirements is to increase the number of switching phases beyond two, for example to four. This enables the decoders to have longer to carry out their decoding operations. In that case it would be necessary to increase the number of clock signals from 2 to 4. These four clock signals would need to be 90° out of phase with one another. Generating and delivering such multiphase clock signals to all of the different segments in the DAC would be very difficult to do in practice. In the switch driver circuitry disclosed in this referenced application, a pair of complimentary clock signals is used directly to provide the drive signals to FETs in the differential switching circuitry to enable such four-phase switching to be realised.

European patent publication EP2023489 discloses switching circuitry for use in high-speed digital-to-analogue converters (DACs), which addresses a further problem relating to switching delay mismatches. A cause of switching delay mismatches in DAC circuitry is a varying voltage potential at current-path connection nodes of the main switching transistors in the DAC circuitry. A first source of the voltage potential variations at the connection nodes is variations in the respective potentials of the output nodes of the DAC. A second source of variations in voltage potential at the connection nodes is a variation dependent on the currents flowing through the main switching transistors. This referenced application discloses current conveyor circuitry operable to shield the connection nodes from variations in potential arising from those two different sources.

European patent publication EP2019490 discloses circuitry for use in digital-to-analogue converters (DACs), which addresses a further problem relating to mismatches in DAC circuitry. This referenced application discloses segmented circuitry comprising a plurality of mutually-similar segments for use in a DAC to address this problem.

Embodiments of the present invention may be employed in devices and apparatuses in base stations, relay stations, mobile terminals or in other radio transmission apparatus, particularly in such transmission apparatus in which multi-band, multi-sector, multi-carrier radio requirements are required. Accordingly, the present invention extends to such devices and apparatuses.

## Claims

1. Apparatus for use in an RF transmitter (400; 1100; 1200; 1300; 1400; 1600), the RF transmitter comprising an amplifier (820; 1120; 1604), an antenna (825; 1125; 1606) operatively connected to said amplifier for transmitting an amplified transmission signal output by said amplifier, and an error-signal generator (835; 1135; 1608) operatively connected to the antenna for producing an error signal in dependence upon a difference between the transmission signal and another signal, the apparatus comprising:

   signal generation means (810; 1110) operable to generate first and second digital RF signals in dependence upon data to be transmitted, the first digital RF signal being a pre-distorted version of the second digital RF signal;
   first DAC means (815; 1115) operable to convert the first digital RF signal into a first analogue RF signal for input to the amplifier to generate said amplified transmission signal; and
second DAC means (830; 1130) operable to convert the second digital RF signal into a second analogue RF signal for input to the error-signal generator as said other signal,
wherein:

   said signal generation means is connectable to the error-signal generator to receive said error signal, and is operable to control generation of said first digital RF signal in dependence upon said error signal so as to tend to reduce said difference;
   said error signal is an RF signal;
   said signal generation means comprises frequency down-conversion means (1160, 1165; 1160, 1302, 1234; 1402, 1234) operable to shift the error signal down in frequency to produce a down-converted error signal; and
   the signal generation means is operable to control generation of said first digital RF signal in dependence upon said down-converted error signal so as to tend to reduce said difference.

2. Apparatus as claimed in claim 1, wherein the signal generation means comprises ADC means (1175) connected for receiving the error signal in analogue form from the error-signal generator and operable to convert the analogue error signal into a corresponding digital signal.

3. Apparatus as claimed in claim 1 or 2, wherein the signal generation means comprises digital frequency up-conversion means (1224, 1226, 1228, 1230, 1232, 1234) operable to generate said first and second digital RF signals from respective first and second digital baseband signals.

4. Apparatus as claimed in any preceding claim, wherein:

   said error signal is an analogue RF signal;
   said frequency down-conversion means comprises an analogue mixer (1160);
   said signal generation means is operable to generate a digital local oscillator signal;
   said signal generation means comprises third DAC means (1302) operatively connected to convert said digital local oscillator signal into an analogue local oscillator signal; and
   said analogue mixer is operatively connected to perform such shift in frequency in dependence upon said analogue local oscillator signal.

5. Apparatus as claimed in any preceding claim, wherein:

said error signal is an analogue RF signal;
said signal generation means is operable to generate a digital local oscillator signal; and
said frequency down-conversion means comprises further DAC means (1402) operatively connected to receive said error signal and said digital local oscillator signal, and is operable to perform said shift in frequency in dependence upon said digital local oscillator signal.

6. Apparatus as claimed in claim 5, wherein:

said further DAC means (1402) comprises current-source means operable to source or sink current of a controllable magnitude; and
said current-source means is connected such that said magnitude is controlled in dependence upon said error signal.

7. Apparatus as claimed in any preceding claim, wherein said first and second digital RF signals each represent complex signals having I and Q components, and each comprise a pair of 1-component and Q-component digital RF signals, and wherein said first and second DAC means each comprise a pair of DACs for converting the I and Q-component digital RF signals of the digital RF signal concerned into respective I and Q-component analogue RF signals.

8. Apparatus as claimed in claim 7 when read as appended to claim 5 or 6, wherein said further DAC means (1402) comprises a pair of DACs for shifting I and Q components of the error signal down in frequency.

9. Apparatus as claimed in any preceding claim, wherein said second DAC means (830; 1130) comprises at least one DAC configured to operate at a sample rate substantially equal to 12GSa/s.

10. Apparatus as claimed in claim 9, wherein each said DAC means comprises at least one DAC configured to operate at a sample rate substantially equal to 12 GSa/s.

11. Apparatus as claimed in any preceding claim, wherein said signal generation means and both or all of said DAC means, as the case may be, are provided together on a single IC chip.

12. An IC chip or chipset, comprising the apparatus as claimed in any preceding claim.

13. A circuit board for use in an RF transmitter (400; 1100; 1200; 1300; 1400; 1600), the RF transmitter comprising an amplifier (820; 1120; 1604) and an antenna (825; 1125; 1606) operatively connected to said amplifier for transmitting an amplified transmission signal output by said amplifier, the circuit board comprising:

apparatus as claimed in any of claims 1 to 11, or an IC chip or chipset as claimed in claim 12; and
said error-signal generator (835; 1135; 1608), operatively connectable to the antenna and operatively connected to the second DAC means, for producing said error signal in dependence upon a difference between the transmission signal and the second analogue RF signal.

14. A circuit board as claimed in claim 13, wherein the signal generation means and the first and second DAC means are provided together on a single IC chip.

15. An RF transmitter (400; 1100; 1200; 1300; 1400; 1600), comprising:

a circuit board as claimed in claim 13 or 14;
said amplifier (820; 1120; 1604), operatively connected to the first DAC means, for producing said amplified transmission signal in dependence upon the first analogue RF signal; and
said antenna (825; 1125; 1606) operatively connected to said amplifier for transmitting said amplified transmission signal

16. An RF transmitter (400; 1100; 1200; 1300; 1400; 1600), comprising:

apparatus as claimed in any of claims 1 to 11, or an IC chip or chipset as claimed in claim 12;
said amplifier (820; 1120; 1604), operatively connected to the first DAC means for producing said amplified transmission signal in dependence upon the first analogue RF signal;
said antenna (825; 1125; 1606) operatively connected to said amplifier for transmitting said amplified transmission signal; and
said error-signal generator (835; 1135; 1608), operatively connected to the antenna and the second DAC means, for producing said error signal in dependence upon a difference between the transmission signal and the second analogue RF signal.

17. An RF transmitter as claimed in claim 15 or 16, wherein said error-signal generator (1608) comprises:

a first input terminal (1610) operatively connected to the antenna (1606) to receive a first input signal in dependence upon said transmission signal;

a second input terminal (1612) operatively connected to the second DAC means to receive a second input signal in dependence upon said second analogue RF signal;

an output terminal (1614) from which said error signal is output;

a resistor (R2) connected between said first input terminal and said output terminal; and

a capacitor (C) connected between said second input terminal and said output terminal.

18. A base station comprising an RF transmitter as claimed in any of claims 15 to 17.

19. A relay station comprising an RF transmitter as claimed in any of claims 15 to 17.

20. A mobile terminal comprising an RF transmitter as claimed in any of claims 15 to 17.

21. A computing device comprising an RF transmitter as claimed in any of claims 15 to 17.

22. A method for use in apparatus of an RF transmitter (400; 1100; 1200; 1300; 1400; 1600), the RF transmitter comprising an amplifier (820; 1120; 1604), an antenna (825; 1125; 1606) operatively connected to said amplifier for transmitting an amplified transmission signal output by said amplifier, and an error-signal generator (835; 1135; 1608) operatively connected to the antenna for producing an error signal in dependence upon a difference between the transmission signal and another signal, the method comprising:

generating first and second digital RF signals in dependence upon data to be transmitted, the first digital RF signal being a pre-distorted version of the second digital RF signal;

converting the first digital RF signal into a first analogue RF signal for input to the amplifier to generate said amplified transmission signal;

converting the second digital RF signal into a second analogue RF signal for input to the error-signal generator as said other signal; and

controlling generation of said first digital RF signal in dependence upon said error signal so as to tend to reduce said difference, wherein:

said error signal is an RF signal;

the method comprises shifting the error signal down in frequency to produce a down-converted error signal; and

the method comprises controlling generation of said first digital RF signal in dependence upon said down-converted error signal so as to tend to reduce said difference.

## Patentansprüche

1. Vorrichtung zur Verwendung in einem Funktransmitter (400; 1100; 1200; 1300; 1400; 1600), wobei der Funktransmitter einen Verstärker (820; 1120; 1604), eine zur Übertragung eines durch den Verstärker ausgegebenen verstärkten Übertragungssignals mit dem Verstärker operativ verbundene Antenne (825; 1125; 1606) und einen zur Erzeugung eines Fehlersignals in Abhängigkeit einer Differenz zwischen dem Übertragungssignal und einem anderen Signal operativ mit der Antenne verbundenen Fehlersignal-Generator (835; 1135; 1608) umfasst, wobei die Vorrichtung umfasst:

Mittel zur Signalerzeugung (810; 1110), betreibbar zur Erzeugung eines ersten und eines zweiten Digitalfunksignals in Abhängigkeit von zu übermittelnden Daten, wobei das erste Digitalfunksignal eine vor-verzerrte Version des zweiten Digitalfunksignals ist;

erste DAC Mittel (800; 1115), betreibbar zur Konvertierung des ersten Digitalfunksignals in ein erstes analoges Funksignal zur Eingabe an den Verstärker zur Erzeugung des verstärkten Übertragungssignals; und

zweite DAC Mittel (830; 1130) betreibbar zur Konvertierung des zweiten Digitalsignals in ein zweites analoges Funksignal zur Eingabe an den Fehlersignal-Generator als das andere Signal,

wobei:

die Mittel zur Signalerzeugung mit dem Fehlersignal-Generator zum Erhalten des Fehlersignals verbindbar sind, und zur Steuerung der Erzeugung des ersten digitalen Funksignals in Abhängigkeit von dem Fehlersignal betreibbar sind, so dass dies zur Reduzierung der Differenz neigt;

das Fehlersignal ein Funksignal ist;

die Mittel zur Signalerzeugung Mittel zur Frequenz-Down-Konvertierung (1160, 1165; 1160, 1302, 1234; 1402, 1234) umfassen, betreibbar zur Verschiebung des Fehlersignals in der Frequenz nach unten zur Erzeugung eines Down-konvertierten Fehlersignals; und

die Mittel zur Signalerzeugung zur Steuerung der Erzeugung des ersten Digitalfunksignals in Abhängigkeit von dem Down-konvertierten Fehlersignal betreibbar sind, so dass dies zur Reduzierung der Differenz neigt.

**2.** Die Vorrichtung wie in Anspruch 1 beansprucht, wobei die Mittel zur Signalerzeugung ADC Mittel (1175) umfassen, welche zum Erhalten des Fehlersignals in analoger Form von dem Fehlersignal-Generator verbunden sind und zur Konvertierung des analogen Fehlersignals in ein entsprechendes Digitalsignal betreibbar sind.

**3.** Die Vorrichtung wie in Anspruch 1 oder 2 beansprucht, wobei die Mittel zur Signalerzeugung Mittel zur digitalen Up-Konvertierung der Frequenz (1224, 1226, 1228, 1230, 1232, 1234) umfassen, betreibbar zur Erzeugung des ersten und zweiten Digitalfunksignals aus entsprechenden ersten und zweiten Digital-Basisbandsignalen .

**4.** Die Vorrichtung wie in einem der vorstehenden Ansprüche beansprucht, wobei:

das Fehlersignal ein analoges Funksignal ist;
die Mittel zur Frequenz-Down-Konvertierung einen Analogmischer (1160) umfassen;
die Mittel zur Signalerzeugung zur Erzeugung eines digitalen lokalen Oszillatorsignals betreibbar sind;
die Mittel zur Signalerzeugung operativ zur Konvertierung des digitalen lokalen Oszillatorsignals in ein analoges lokales Oszillatorsignal verbundene dritte DAC Mittel (1302) umfassen; und
der Analogmischer zur Erzeugung einer solchen Frequenzverschiebung in Abhängigkeit von dem analogen lokalen Oszillatorsignal operativ verbunden ist.

**5.** Die Vorrichtung wie in einem der vorhergehenden Ansprüche beansprucht, wobei:

das Fehlersignal ein analoges Funksignal ist;
die Mittel zur Signalerzeugung zur Erzeugung eines digitalen lokalen Oszillatorsignals betreibbar sind; und
die Mittel zur Frequenz-Down-Konvertierung zum Erhalten des Fehlersignals und des digitalen lokalen Oszillatorsignals operativ verbundene weitere DAC Mittel (1402) umfassen, und zur Erzeugung der Frequenzverschiebung in Abhängigkeit von dem digitalen lokalen Oszillatorsignal betreibbar sind.

**6.** Vorrichtung wie in Anspruch 5 beansprucht, wobei:

die weiteren DAC Mittel (1402) zum Versorgen und zum Abführen von Strom einer einstellbaren Größe betreibbare Stromquellen-Mittel umfassen; und
die Stromquellen-Mittel derart verbunden sind, dass die Größe in Abhängigkeit von dem Fehlersignal gesteuert ist.

**7.** Vorrichtung wie in einem der vorhergehenden Ansprüche, wobei die ersten und zweiten Digitalfunksignale jeweils I und Q Komponenten aufweisende komplexe Signale darstellen und jeweils ein Paar von I-Komponente und Q-Komponente Digitalfunksignale umfassen, und wobei die ersten und zweiten DAC Mittel jeweils ein Paar von DACs zur Konvertierung der I- und Q-Komponente Digitalfunksignale des betroffenen Digitalfunksignals in entsprechende I- und Q-Komponenten eines analogen Funksignals umfassen.

**8.** Vorrichtung wie Anspruch 7 beansprucht, wenn in Abhängigkeit zu Anspruch 5 oder 6 gelesen, wobei die weiteren DAC Mittel (1402) ein Paar von DACs zur Verschiebung der I und Q Komponenten des Fehlersignals in der Frequenz nach unten umfassen.

**9.** Vorrichtung wie in einem der vorhergehenden Ansprüche beansprucht, wobei die zweiten DAC Mittel (830; 1130) zumindest einen DAC zum Betreiben mit einer Abtastrate von im Wesentlichen gleich 12 GSa/s umfassen.

**10.** Vorrichtung wie in Anspruch 9 beansprucht, wobei jede der DAC Mittel zumindest einen DAC zum Betreiben mit einer Abtastrate von im Wesentlichen gleich 12 GSa/s umfassen.

**11.** Vorrichtung wie in einem der vorhergehenden Ansprüche beansprucht, wobei die Mittel zur Signalerzeugung und beide oder alle der DAC Mittel, wie es der Fall sein mag, zusammen auf einem einzelnen IC Chip vorgesehen sind.

**12.** Ein IC Chip oder Chipsatz umfassend die Vorrichtung wie in einem der vorhergehenden Ansprüche beansprucht.

**13.** Eine Leiterplatte zur Verwendung in einem Funktransmitter (400; 1100; 1200; 1300; 1400; 1600), wobei der Funktransmitter einen Verstärker (820; 1120; 1604) und eine zur Übertragung eines durch den Verstärker ausgegebenen verstärkten Übertragungssignals mit dem Verstärker operativ verbundene Antenne (825; 1125; 1606) umfasst, wobei die Leiterplatte umfasst:

eine Vorrichtung wie in einem der Ansprüche 1 bis 11 beansprucht oder einen IC Chip oder Chipsatz wie in Anspruch 12 beansprucht; und den operativ mit der Antenne verbundenen und operativ mit den zweiten DAC Mitteln verbundenen Fehlersignal-Generator (835; 1135; 1608) zur Erzeugung des Fehlersignals in Abhängigkeit von einer Differenz zwischen dem Übertragungssignal und dem zweiten analogen Funksignal.

**14.** Eine Leiterplatte wie in Anspruch 13 beansprucht, wobei die Mittel zur Signalerzeugung und die ersten und zweiten DAC Mittel zusammen auf einem einzelnen IC Chip vorgesehen sind.

**15.** Ein Funktransmitter (400; 1100; 1200; 1300; 1400; 1600), umfassend:

eine Leiterplatte wie in Anspruch 13 oder 14 beansprucht;
den operativ mit den ersten DAC Mitteln verbundenen Verstärker (820; 1180; 1604) zur Erzeugung des verstärkten Übertragungssignals in Abhängigkeit von dem ersten analogen Funksignal; und
die operativ mit dem Verstärker zur Übertragung des verstärkten Übertragungssignals verbundene Antenne.

**16.** Ein Funktransmitter (400; 1100; 1200; 1300; 1400; 1600), umfassend:

eine Vorrichtung wie in einem der Ansprüche 1 bis 11 beansprucht oder einen IC Chip oder Chipsatz wie in Anspruch 12 beansprucht;
den operativ mit den ersten DAC Mitteln verbundenen Verstärker (820; 1120; 1604) zur Erzeugung des verstärkten Übertragungssignals in Abhängigkeit von dem ersten analogen Funksignal;
die operativ mit dem Verstärker zur Übertragung des verstärkten Übertragungssignals verbundene Antenne; und
den operativ mit der Antenne und mit den zweiten DAC Mitteln verbundenen Fehlersignal-Generator (835; 1135; 1608) zur Erzeugung des Fehlersignals in Abhängigkeit von einer Differenz zwischen dem Übertragungssignal und dem zweiten analogen Funksignal.

**17.** Ein Funktransmitter wie in Anspruch 15 oder 16 beansprucht, wobei der Fehlersignal-Generator (1608) umfasst:

einen operativ mit der Antenne (1606) zum Erhalten eines ersten Eingabesignals in Abhängigkeit von dem Übertragungssignal verbundenen ersten Eingangsanschluss (1610);
einen operativ mit den zweiten DAC Mitteln zum Erhalten eines zweiten Eingabesignals in Abhängigkeit von dem zweiten analogen Funksignal verbundenen zweiten Eingangsanschluss (1612);
einen Ausgabeanschluss (1614), von dem aus das Fehlersignal ausgegeben wird,
einen zwischen dem ersten Eingangsanschluss und dem Ausgangsanschluss verbundenen Widerstand (R2); und

eine zwischen dem zweiten Eingangsanschluss und dem Ausgangsanschluss verbundene Kapazität (C).

**18.** Eine Basisstation umfassend einen wie in einem der Ansprüche 15 bis 17 beanspruchten Funktransmitter.

**19.** Eine Relaisstation umfassend einen wie in einem der Ansprüche 15 bis 17 beanspruchten Funktransmitter.

**20.** Ein mobiles Endgerät umfassend einen wie in einem der Ansprüche 15 bis 17 beanspruchten Funktransmitter.

**21.** Eine Rechenvorrichtung umfassend einen wie in einem der Ansprüche 15 bis 17 beanspruchten Funktransmitter.

**22.** Ein Verfahren zur Verwendung in einer Vorrichtung eines Funktransmitter (400; 1100; 1200; 1300; 1400; 1600), wobei der Funktransmitter einen Verstärker (820; 1120; 1604), eine zur Übertragung eines durch den Verstärker ausgegebenen verstärkten Übertragungssignals mit dem Verstärker operativ verbundene Antenne (825; 1125; 1606) und einen zur Erzeugung eines Fehlersignals in Abhängigkeit einer Differenz zwischen dem Übertragungssignal und einem anderen Signal operativ mit der Antenne verbundenen Fehlersignal-Generator (835; 1135; 1608) umfasst, wobei das Verfahren umfasst:

Erzeugen eines ersten und zweiten Digitalfunksignals in Abhängigkeit von zu übermittelnden Daten, wobei das erste Digitalfunksignal eine vor-verzerrte Version des zweiten Digitalfunksignals ist;
Konvertieren des ersten Digitalfunksignals in ein erstes analoges Funksignal zur Eingabe an den Verstärker zur Erzeugung des verstärkten Übertragungssignals;
Konvertieren des zweiten Digitalfunksignals in ein zweites analoges Funksignal zur Eingabe an den Fehler Signal-Generator als das andere Signal; und
Steuern einer Erzeugung des ersten Digitalfunksignals in Abhängigkeit von dem Fehlersignal, so dass dies zur Reduzierung der Differenz neigt,
wobei:

das Fehlersignal ein Funksignal ist;
das Verfahren ein Verschieben des Fehlersignals in der Frequenz nach unten zur Erzeugung eines Down-konvertierten Fehlersignals umfasst; und
das Verfahren ein Steuern einer Erzeugung des ersten Digitalfunksignals in Abhängigkeit von dem Down-konvertierten Fehlersignals umfasst, so dass dies zur Reduzierung der Differenz neigt.

## Revendications

1. Appareil pour une utilisation dans un émetteur RF (400 ; 1100 ; 1200 ; 1300 ; 1400 ; 1600), l'émetteur RF comprenant un amplificateur (820 ; 1120 ; 1604), une antenne (825 ; 1125 ; 1606) connectée de manière fonctionnelle au dit amplificateur pour émettre un signal d'émission amplifié délivré par ledit amplificateur, et un générateur de signal d'erreur (835 ; 1135 ; 1608) connecté de manière fonctionnelle à l'antenne pour produire un signal d'erreur sur la base d'une différence entre le signal d'émission et un autre signal, l'appareil comprenant :

   des moyens de génération de signal (810 ; 1110) pouvant être utilisés pour générer des premier et deuxième signaux RF numériques en fonction de données à émettre, le premier signal RF numérique étant une version déformée au préalable du deuxième signal RF numérique ;
   des premiers moyens de conversion numérique-analogique (815 ; 1115) pouvant être utilisés pour convertir le premier signal RF numérique en un premier signal RF analogique pour une application à l'amplificateur pour générer ledit signal d'émission amplifié ; et
   des deuxièmes moyens de conversion numérique-analogique (830 ; 1130) pouvant être utilisés pour convertir le deuxième signal RF numérique en un deuxième signal RF analogique pour une application au générateur de signal d'erreur en tant que dit autre signal,
   dans lequel :

   lesdits moyens de génération de signal peuvent être connectés au générateur de signal d'erreur pour recevoir ledit signal d'erreur, et peuvent être utilisés pour commander la génération dudit premier signal RF numérique sur la base dudit signal d'erreur de manière à tendre à réduire ladite différence ;
   ledit signal d'erreur est un signal RF ;
   lesdits moyens de génération de signal comprennent des moyens de conversion-abaissement de fréquence (1160, 1165 ; 1160, 1302, 1234 ; 1402, 1234) pouvant être utilisés pour abaisser le signal d'erreur en fréquence pour produire un signal d'erreur converti-abaissé ; et
   les moyens de génération de signal peuvent être utilisés pour commander la génération dudit premier signal RF numérique sur la base dudit signal d'erreur converti-abaissé de manière à tendre à réduire ladite différence.

2. Appareil selon la revendication 1, dans lequel les moyens de génération de signal comprennent des moyens de conversion analogique-numérique (1175) connectés pour recevoir le signal d'erreur sous une forme analogique du générateur de signal d'erreur et pouvant être utilisés pour convertir le signal d'erreur analogique en un signal numérique correspondant.

3. Appareil selon la revendication 1 ou 2, dans lequel les moyens de génération de signal comprennent des moyens de conversion-élévation de fréquence numérique (1224, 1226, 1228, 1230, 1232, 1234) pouvant être utilisés pour générer lesdits premier et deuxième signaux RF numériques à partir de premier et deuxième signaux de bande de base numériques respectifs.

4. Appareil selon l'une quelconque des revendications précédentes, dans lequel :

   ledit signal d'erreur est un signal RF analogique ;
   lesdits moyens de conversion-abaissement de fréquence comprennent un mélangeur analogique (1160) ;
   lesdits moyens de génération de signal peuvent être utilisés pour générer un signal d'oscillateur local numérique ;
   lesdits moyens de génération de signal comprennent des troisièmes moyens de conversion numérique-analogique (1302) connectés de manière fonctionnelle pour convertir ledit signal d'oscillateur local numérique en un signal d'oscillateur local analogique ; et
   ledit mélangeur analogique est connecté de manière fonctionnelle pour effectuer ce décalage de fréquence sur la base dudit signal d'oscillateur local analogique.

5. Appareil selon l'une quelconque des revendications précédentes, dans lequel :

   ledit signal d'erreur est un signal RF analogique ;
   lesdits moyens de génération de signal peuvent être utilisés pour générer un signal d'oscillateur local numérique ; et
   lesdits moyens de conversion-abaissement de fréquence comprennent en outre des moyens de conversion numérique-analogique supplémentaires (1402) connectés de manière fonctionnelle pour recevoir ledit signal d'erreur et ledit signal d'oscillateur local numérique, et peuvent être utilisés pour effectuer ledit décalage de fréquence sur la base dudit signal d'oscillateur local numérique.

6. Appareil selon la revendication 5, dans lequel :

lesdits moyens de conversion numérique-analogique supplémentaires (1402) comprennent des moyens formant source de courant pouvant être utilisés pour fournir ou consommer un courant d'une amplitude pouvant être commandée ; et
lesdits moyens formant source de courant sont connectés de sorte que ladite amplitude soit commandée sur la base dudit signal d'erreur.

7. Appareil selon l'une quelconque des revendications précédentes, dans lequel lesdits premier et deuxième signaux RF numériques représentent chacun des signaux complexes ayant des composantes I et Q, et comprennent chacun une paire de signaux RF numériques à composante I et à composante Q, et dans lequel lesdits premiers et deuxièmes moyens de conversion numérique-analogique comprennent chacun une paire de convertisseurs numérique-analogique pour convertir les signaux RF numériques à composantes I et Q du signal RF numérique concerné en des signaux RF analogiques à composantes I et Q respectifs.

8. Appareil selon la revendication 7 lorsqu'elle est lue telle que jointe à la revendication 5 ou 6, dans lequel lesdits moyens de conversion numérique-analogique supplémentaires (1402) comprennent une paire de convertisseurs numérique-analogique pour abaisser les composantes I et Q du signal d'erreur en fréquence.

9. Appareil selon l'une quelconque des revendications précédentes, dans lequel lesdits deuxièmes moyens de conversion numérique-analogique (830 ; 1130) comprennent au moins un convertisseur numérique-analogique configuré pour fonctionner à une fréquence d'échantillonnage sensiblement égale à 12 GSa/s.

10. Appareil selon la revendication 9, dans lequel chaque dit moyen de conversion numérique-analogique comprend au moins un convertisseur numérique-analogique configuré pour fonctionner à une fréquence d'échantillonnage sensiblement égale à 12 GSa/s.

11. Appareil selon l'une quelconque des revendications précédentes, dans lequel lesdits moyens de génération de signal et les deux ou la totalité desdits moyens de conversion numérique-analogique, selon le cas, sont prévus, ensemble, sur une puce de circuit intégré unique.

12. Puce de circuit intégré ou jeu de puces, comprenant l'appareil selon l'une quelconque des revendications précédentes.

13. Carte de circuit pour une utilisation dans un émetteur RF (400 ; 1100 ; 1200 ; 1300 ; 1400 ; 1600), l'émetteur RF comprenant un amplificateur (820 ; 1120 ; 1604) et une antenne (825 ; 1125 ; 1606) connecté de manière fonctionnelle au dit amplificateur pour émettre un signal d'émission amplifié délivré par ledit amplificateur, la carte de circuit comprenant :

un appareil selon l'une quelconque des revendications 1 à 11, ou une puce de circuit intégré ou un jeu de puces selon la revendication 12 ; et
ledit générateur de signal d'erreur (835 ; 1135 ; 1608), pouvant être connecté de manière fonctionnelle à l'antenne et connecté de manière fonctionnelle aux deuxièmes moyens de conversion numérique-analogique, pour produire ledit signal d'erreur sur la base d'une différence entre le signal d'émission et le deuxième signal RF analogique.

14. Carte de circuit selon la revendication 13, dans lequel les moyens de génération de signal et les premiers et deuxièmes moyens de conversion numérique-analogique sont prévus, ensemble, sur une puce de circuit intégré unique.

15. Emetteur RF (400 ; 1100 ; 1200 ; 1300 ; 1400 ; 1600), comprenant :

une carte de circuit selon la revendication 13 ou 14 ;
ledit amplificateur (820 ; 1120 ; 1604), connecté de manière fonctionnelle aux premiers moyens de conversion numérique-analogique, pour produire ledit signal d'émission amplifié sur la base du premier signal RF analogique ; et
ladite antenne (825 ; 1125 ; 1606) connectée de manière fonctionnelle au dit amplificateur pour émettre ledit signal d'émission amplifié.

16. Emetteur RF (400 ; 1100 ; 1200 ; 1300 ; 1400 ; 1600), comprenant :

un appareil selon l'une quelconque des revendications 1 à 11, ou une puce de circuit intégré ou un jeu de puces selon la revendication 12 ;
ledit amplificateur (820 ; 1120 ; 1604), connecté de manière fonctionnelle aux premiers moyens de conversion numérique-analogique, pour produire ledit signal d'émission amplifié sur la base du premier signal RF analogique ;
ladite antenne (825 ; 1125 ; 1606) connectée de manière fonctionnelle au dit amplificateur pour émettre ledit signal d'émission amplifié ; et ledit générateur de signal d'erreur (835 ; 1135 ; 1608), connecté de manière fonctionnelle à l'antenne et aux deuxièmes moyens de conversion numérique-analogique, pour produire ledit signal d'erreur sur la base d'une différence entre le signal d'émission et le deuxième signal RF analogique.

17. Emetteur RF selon la revendication 15 ou 16, dans lequel ledit générateur de signal d'erreur (1608) comprend :

une première borne d'entrée (1610) connectée de manière fonctionnelle à l'antenne (1606) pour recevoir un premier signal d'entrée sur la base dudit signal d'émission ;
une deuxième borne d'entrée (1612) connectée de manière fonctionnelle aux deuxièmes moyens de conversion numérique-analogique pour recevoir un deuxième signal d'entrée sur la base dudit deuxième signal RF analogique ;
une borne de sortie (1614) à partir de laquelle ledit signal d'erreur est délivré ;
une résistance (R2) connectée entre ladite première borne d'entrée et ladite borne de sortie ; et
un condensateur (C) connecté entre ladite deuxième borne d'entrée et ladite borne de sortie.

18. Station de base comprenant un émetteur RF selon l'une quelconque des revendications 15 à 17.

19. Station relais comprenant un émetteur RF selon l'une quelconque des revendications 15 à 17.

20. Terminal mobile comprenant un émetteur RF selon l'une quelconque des revendications 15 à 17.

21. Dispositif informatique comprenant un émetteur RF selon l'une quelconque des revendications 15 à 17.

22. Procédé pour une utilisation dans un appareil d'un émetteur RF (400 ; 1100 ; 1200 ; 1300 ; 1400 ; 1600), l'émetteur RF comprenant un amplificateur (820 ; 1120 ; 1604), une antenne (825 ; 1125 ; 1606) connectée de manière fonctionnelle au dit amplificateur pour émettre un signal d'émission amplifié délivré par ledit amplificateur, et un générateur de signal d'erreur (835 ; 1135 ; 1608) connecté de manière fonctionnelle à l'antenne pour produire un signal d'erreur sur la base d'une différence entre le signal d'émission et un autre signal, le procédé comprenant :

la génération de premier et deuxième signaux RF numériques sur la base de données à émettre, le premier signal RF numérique étant une version déformée au préalable du deuxième signal RF numérique ;
la conversion du premier signal RF numérique en un premier signal RF analogique pour une application à l'amplificateur pour générer ledit signal d'émission amplifié ;
la conversion du deuxième signal RF numérique en un deuxième signal RF analogique pour une application au générateur de signal d'erreur en tant que dit autre signal ; et
la commande de la génération dudit premier signal RF numérique sur la base dudit signal d'erreur de manière à tendre à réduire ladite différence,
dans lequel :

ledit signal d'erreur est un signal RF ;
le procédé comprend l'abaissement du signal d'erreur en fréquence pour produire un signal d'erreur converti-abaissé ; et
le procédé comprend la commande de la génération dudit premier signal RF numérique sur la base dudit signal d'erreur converti-abaissé de manière à tendre à réduire ladite différence.

FIG. 1

100

2

$V_{TX}$

102

PDDS →   +D1

16

$V_{IN}$ →

104

$V_{ADC}$ ←   +D2

FIG. 2

| ORDER | INTERMODULATION PRODUCTS | |
|---|---|---|
| 1$^{ST}$ | $f_1 = 100$ kHz | $f_2 = 101$ kHz |
| 2$^{ND}$ | $f_1+f_2 = 201$ kHz | $f_2-f_1 = 1$ Hz |
| 3$^{RD}$ | $2f_1-f_2 = 99$ kHz<br>$2f_1+f_2 = 301$ kHz | $2f_2-f_1 = 102$ kHz<br>$2f_2+f_1 = 302$ kHz |
| 4$^{TH}$ | $2f_2+2f_1 = 402$ kHz | $2f_1-2f_1 = 2$ kHz |
| 5$^{TH}$ | $3f_1-2f_2 = 98$ kHz<br>$3f_1+2f_2 = 502$ kHz | $3f_2-2f_1 = 103$ kHz<br>$3f_2+2f_1 = 503$ kHz |

FIG. 3A

FIG. 3B

FIG. 4

EP 2 019 486 B1

FIG. 5

FIG. 6

EP 2 019 486 B1

FIG. 7

EP 2 019 486 B1

FIG. 8

EP 2 019 486 B1

FIG. 9

Offset of closest spurious component for different Tx bands

FIG. 10

EP 2 019 486 B1

FIG. 11

EP 2 019 486 B1

FIG. 12

EP 2 019 486 B1

FIG. 13

EP 2 019 486 B1

FIG. 14

EP 2 019 486 B1

D — (DATA) → DAC → A (RF SIGNAL)

CLK

FIG. 15A

$A^*$ (ERROR)

D (DIGITAL LO) → $I_{TAIL}$ DAC → A (DOWN-CONVERTED ERROR)

CLK

FIG. 15C

A (RF SIGNAL)

D (DATA)

$I_{TAIL}$ = constant

FIG. 15B

A (DOWN-CONVERTED ERROR)

D (DIGITAL LO)

$I_{TAIL}$ = MODULATED WITH $A^*$ (ERROR)

FIG. 15D

EP 2 019 486 B1

FIG. 16

EP 2 019 486 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070030065 A1
- US 4291277 A
- US 6141390 A
- US 6992609 B
- EP 2019427 A
- EP 2023487 A
- EP 2019487 A
- EP 2023489 A
- EP 2019490 A

**Non-patent literature cited in the description**

- **LUSCHAS, S et al.** Radio frequency digital-to-analog converter. *IEEE Journal of Solid-State Circuits,* September 2004, vol. 39 (9), 1462-1467